(19) Europäisches Patentamt
European Patent Office
Office européen des brevets

(11) **EP 4 693 267 A1**

(12) **EUROPEAN PATENT APPLICATION**
published in accordance with Art. 153(4) EPC

(43) Date of publication:
**11.02.2026 Bulletin 2026/07**

(21) Application number: **24806129.3**

(22) Date of filing: **21.02.2024**

(51) International Patent Classification (IPC):
**G09G 3/3208** (2016.01)   **G11C 19/28** (2006.01)
**G02F 1/13** (2006.01)

(52) Cooperative Patent Classification (CPC):
**G02F 1/13; G09G 3/3208; G09G 3/3225;
G11C 19/28**

(86) International application number:
**PCT/CN2024/077960**

(87) International publication number:
**WO 2024/234768 (21.11.2024 Gazette 2024/47)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **12.05.2023   CN 202310541140
21.12.2023   CN 202311790984**

(71) Applicant: **Huawei Technologies Co., Ltd.
Shenzhen, Guangdong 518129 (CN)**

(72) Inventors:
• **HUANG, Qiangcan
Shenzhen, Guangdong 518129 (CN)**

• **BAI, Wei
Shenzhen, Guangdong 518129 (CN)**
• **LI, Xiuling
Shenzhen, Guangdong 518129 (CN)**
• **LIU, Cang
Shenzhen, Guangdong 518129 (CN)**
• **YAMASHITA, Keitaro
Shenzhen, Guangdong 518129 (CN)**
• **TERANISHI, Yasuyuki
Shenzhen, Guangdong 518129 (CN)**
• **TAKATORI, Kenichi
Shenzhen, Guangdong 518129 (CN)**

(74) Representative: **Maiwald GmbH
Elisenhof
Elisenstraße 3
80335 München (DE)**

(54) **DRIVE CIRCUIT AND DRIVE METHOD**

(57)    A drive circuit and a driving method are provided, and relate to the field of display technologies, to resolve a problem of inconsistent pulse widths of overlapping pulse signals in different rows during partition refresh. A drive circuit (50) includes a plurality of first GOA circuits (51) and p first partition control signal lines (52), p is an integer greater than or equal to 2, the plurality of first GOA circuits (51) are sequentially cascaded, the plurality of first GOA circuits (51) include n first GOA circuit combinations, n is an integer greater than or equal to p, and first GOA circuits (51) in each first GOA circuit combination are sequentially cascaded; and a partition control end of each first GOA circuit (51) in a $(px+y)^{th}$ first GOA circuit combination in the n first GOA circuit combinations is coupled to a $y^{th}$ first partition control signal line (52) in the p first partition control signal lines (52), x is an integer greater than or equal to 0 and less than or equal to $(n-y)/p$, and y is an integer greater than or equal to 1 and less than or equal to p.

Processed by Luminess, 75001 PARIS (FR)

EP 4 693 267 A1

FIG. 5

**Description**

This application claims priorities to Chinese Patent Application No. 202310541140.9, filed with the China National Intellectual Property Administration on May 12, 2023, and entitled "DRIVE CIRCUIT AND DRIVING METHOD", and to Chinese Patent Application No. 202311790984.3, filed with the China National Intellectual Property Administration on December 21, 2023, and entitled "DRIVE CIRCUIT AND DRIVING METHOD", both of which are incorporated herein by reference in their entireties.

**TECHNICAL FIELD**

This application relates to the field of display technologies, and in particular, to a drive circuit and a driving method.

**BACKGROUND**

Currently, to improve users' video or game experience, organic light-emitting diode (organic light-emitting diode, OLED) displays requires a very high refresh frequency (for example, 120 hertz (hertz, Hz)). The high refresh frequency causes high power consumption of the display and reduced battery life. To reduce power consumption and extend battery life, the existing OLED displays use a low-temperature polycrystalline oxide (low-temperature polycrystalline oxide, LTPO) technology. This allows the displays to operate at a high refresh frequency in video or game scenarios, and switch to a low refresh frequency (for example, 1 Hz) when displaying static pictures, thereby effectively reducing power consumption.

In the LTPO technology, a partition circuit is added to a gate driver on array (gate scan circuit on array, GOA) circuit. The partition circuit includes two thin film transistors (thin film transistor, TFT): T1 and T2. T1 and T2 are controlled by a partition control signal. When the partition control signal is at a high level, the GOA outputs a valid pulse signal, or when the partition control signal is at a low level, the GOA does not output a valid pulse signal. When a partitioning function is enabled, that is, an area that needs to be refreshed and an area that does not need to be refreshed are included, if pulse signals in different areas overlap, when a level of the partition control signal is switched, a pulse width of a pulse signal in the area that needs to be refreshed is inconsistent with a required pulse width. In addition, a longer overlapping area of pulse signals indicates a more severe case of pulse width inconsistency.

**SUMMARY**

Embodiments of this application provide a drive circuit and a driving method, so that a level of a pulse signal of a GOA circuit combination is controlled by using a plurality of partition control signal lines, thereby resolving a problem that a pulse signal width is inconsistent with a required pulse width.

To achieve the foregoing objectives, the following technical solutions are used in embodiments of this application.

According to a first aspect, an embodiment of this application provides a drive circuit. The drive circuit includes a plurality of first gate driver on array GOA circuits and p first partition control signal lines, p is an integer greater than or equal to 2, the plurality of first GOA circuits are sequentially cascaded, the plurality of first GOA circuits include n first GOA circuit combinations, n is an integer greater than or equal to p, and first GOA circuits in each first GOA circuit combination are sequentially cascaded; and a partition control end of each first GOA circuit in a $(px+y)^{th}$ first GOA circuit combination in the n first GOA circuit combinations is coupled to a $y^{th}$ first partition control signal line in the p first partition control signal lines, x is an integer greater than or equal to 0 and less than or equal to $(n-y)/p$, and y is an integer greater than or equal to 1 and less than or equal to p.

Therefore, in this embodiment of this application, a coupling manner between the n first GOA circuit combinations and the p first partition control signal lines may be understood as an alternating connection, and one first GOA circuit combination may be understood as one partition. In other words, first GOA circuit combinations of different partitions may be controlled by different first partition control signal lines. Therefore, during partition refresh, for overlapping pulse signals, it can be ensured that a pulse signal of a first GOA circuit coupled to a current first partition control signal line is not affected by level switching of another first partition control signal line, and it is ensured that a width of the pulse signal is the same as an actual required width, thereby implementing a partitioning function.

In a possible design, the drive circuit further includes a second partition control signal line, a third partition control signal line, a plurality of control circuits, and a plurality of second GOA circuits; and the plurality of second GOA circuits are sequentially cascaded, the plurality of second GOA circuits include a plurality of second GOA circuit combinations, second GOA circuits in each second GOA circuit combination are sequentially cascaded, a quantity of second GOA circuit combinations is the same as a quantity of control circuits, control ends of the plurality of control circuits are coupled to the second partition control signal line and the third partition control signal line, a first end of each control circuit in the plurality of control circuits is coupled to the first GOA circuit combination, and a second end of each control circuit in the plurality of control circuits is coupled to the corresponding second GOA circuit combination.

In this design, the control circuit controls an input signal in the second GOA circuit combination, and one end of the control circuit is coupled to the first GOA circuit combination, so that when the second GOA circuit outputs no pulse signal, a frequency of a corresponding clock signal can be reduced, thereby reducing power consumption.

In a possible design, the control circuit includes a first thin film transistor and a second thin film transistor; a drain of the first thin film transistor is coupled to the first end of the control circuit, a gate of the first thin film transistor is coupled to the second partition control signal line, and a source of the first thin film transistor is coupled to the second end of the control circuit; and a drain of the second thin film transistor is coupled to a power output end, a gate of the second thin film transistor is coupled to the third partition control signal line, and a source of the second thin film transistor is coupled to the second end of the control circuit.

In this design, the drain of the first thin film transistor in the control circuit may be coupled to a node that is in the first GOA circuit and that has a low-level pulse signal with a row-by-row shift, and provide a low level for an input end of the second GOA circuit in combination with the second partition control signal line. The drain of the second thin film transistor in the control circuit may be coupled to a power output end having a high level, and provide a high level for the input end of the second GOA circuit in combination with the third partition control signal line. Alternatively, the drain of the first thin film transistor in the control circuit may be coupled to a node that is in the first GOA circuit and that has a high-level pulse signal with a row-by-row shift, and provide a high level for an input end of the second GOA circuit in combination with the second partition control signal line. The drain of the second thin film transistor in the control circuit may be coupled to a power output end having a low level, and provide a low level for the input end of the second GOA circuit in combination with the third partition control signal line.

In a possible design, the drive circuit further includes a fourth partition control signal line, a gate of the first thin film transistor of a $(2i-1)^{th}$ control circuit in the plurality of control circuits is coupled to the second partition control signal line, i is a positive integer, and a gate of the first thin film transistor of a $(2i)^{th}$ control circuit in the plurality of control circuits is coupled to the fourth partition control signal line.

In this design, the fourth partition control signal line is disposed, so that when input pulse signals of the input end of the second GOA circuit are overlapping pulse signals, a case in which the pulse signal of the second GOA circuit is incorrectly output can be avoided.

In a possible design, the control circuit includes a third thin film transistor and a fourth thin film transistor; a drain of the third thin film transistor is coupled to the second partition control signal line, a gate of the third thin film transistor is coupled to the first end of the control circuit, and a source of the third thin film transistor is coupled to the second end of the control circuit; and a drain of the fourth thin film transistor is coupled to a power output end, a gate of the fourth thin film transistor is coupled to the third partition control signal line, and a source of the fourth thin film transistor is coupled to the second end of the control circuit.

In this design, the gate of the third thin film transistor in the control circuit may be coupled to a node that is in the first GOA circuit and that has a low-level pulse signal with a row-by-row shift, and provide a low level for an input end of the second GOA circuit in combination with the second partition control signal line. The drain of the fourth thin film transistor in the control circuit may be coupled to a power output end having a high level, and provide a high level for the input end of the second GOA circuit in combination with the third partition control signal line. Alternatively, the gate of the third thin film transistor in the control circuit may be coupled to a node that is in the first GOA circuit and that has a high-level pulse signal with a row-by-row shift, and provide a high level for an input end of the second GOA circuit in combination with the second partition control signal line. The drain of the fourth thin film transistor in the control circuit may be coupled to a power output end having a low level, and provide a low level for the input end of the second GOA circuit in combination with the third partition control signal line. In addition, a coupling manner between the third thin film transistor and the first end of the control circuit and the second partition control signal line can ensure that the input end of the second GOA circuit obtains a valid pulse signal.

In a possible design, the drive circuit further includes a fifth partition control signal line, a drain of the third thin film transistor of a $(2j-1)^{th}$ control circuit in the plurality of control circuits is coupled to the second partition control signal line, j is a positive integer, and a drain of the third thin film transistor of a $(2j)^{th}$ control circuit in the plurality of control circuits is coupled to the fifth partition control signal line.

In this design, the fifth partition control signal line is disposed, so that when input pulse signals of the input end of the second GOA circuit are overlapping pulse signals, a case in which the pulse signal of the second GOA circuit is incorrectly output can be avoided.

In a possible design, the drive circuit further includes a plurality of fifth thin film transistors and a sixth partition control signal line, a drain of the fifth thin film transistor is coupled to an output end of a last second GOA circuit in the second GOA circuit combination, a source of the fifth thin film transistor is coupled to an input end of a 1 st second GOA circuit in a next second GOA circuit combination, and a gate of the fifth thin film transistor is coupled to the sixth partition control signal line.

In this design, the fifth thin film transistor and the sixth partition control signal line are disposed, so that when there are a large quantity of partition units, and pulse signals of most partition units do not change abruptly, low levels of the second partition control signal line and the third partition control signal line can be kept unchanged, thereby reducing a quantity of switching times of the second partition control signal line and the third control signal line, and further reducing power consumption.

In a possible design, the drive circuit further includes a start-of-frame signal line, and a width of a pulse signal of the first GOA circuit is determined by a width of a pulse signal of the start-of-frame signal line.

In this design, the pulse width of the first GOA circuit needs to be set within a proper range. The width of the pulse signal of the first GOA circuit may be adjusted by adjusting the width of the pulse signal of the start-of-frame signal line, to ensure that the width of the pulse signal of the first GOA circuit is consistent with a width of an actual pulse signal during partition refresh.

In a possible design, a quantity of first GOA circuits in the first GOA circuit combination is related to a quantity of first partition control signal lines and the width of the pulse signal of the first GOA circuit.

In this design, the quantity of first GOA circuits in the first GOA circuit combination may be properly set by using the quantity of first partition control signal lines and the width of the pulse signal of the first GOA circuit, to ensure that the width of the pulse signal of the first GOA circuit is consistent with a width of an actual pulse signal during partition refresh.

In a possible design, when the first partition control signal line outputs a high level, the pulse signal of the first GOA circuit is at a high level, or when the first partition control signal line outputs a low level, the pulse signal of the first GOA circuit is at a low level.

In a possible design, each first GOA circuit combination includes m first GOA circuits, m is an integer greater than or equal to 1, and every p first GOA circuit combinations are respectively coupled to the p first partition control signal lines.

In a possible design, each first GOA circuit combination in a 1 st first GOA circuit combination in the n first GOA circuit combinations to a $(p*x1+y1)^{th}$ first GOA circuit combination includes m first GOA circuits, m is an integer greater than or equal to 1, each first GOA circuit combination in a $(p*x1+y1+1)^{th}$ first GOA circuit combination to a $(p*x2+y2)^{th}$ first GOA circuit combination includes j first GOA circuits, and each first GOA circuit combination in a $(p*x2+y2+1)^{th}$ first GOA circuit combination to an $n^{th}$ first GOA circuit combination includes h first GOA circuits, where x1 is an integer greater than or equal to 0 and less than or equal to (n-y)/p, x2 is an integer greater than or equal to x1 and less than or equal to (n-y)/p, y1 is an integer greater than or equal to 1 and less than or equal to p, y2 is an integer greater than or equal to 1 and less than or equal to p, j is an integer greater than or equal to 1 and less than or equal to m, and h is an integer greater than or equal to 1 and less than m.

In this design, a quantity of first GOA circuits in the first GOA circuit combination may be flexibly adjusted, to match different resolution requirements of a pixel screen.

In a possible design, the drive circuit further includes a third GOA circuit combination and a fourth GOA circuit combination; each first partition control signal line is coupled with g third GOA circuit combinations close to the first end, and each first partition control signal line is coupled with k fourth GOA circuit combinations close to the second end, where g is an integer greater than or equal to 1, and k is an integer greater than or equal to 1; and output pulse signals of the third GOA circuit combination and the fourth GOA circuit combination are not transmitted to a pixel screen.

In this design, the third GOA circuit combination is disposed at a position of each first partition control signal line close to the first end, and the fourth GOA circuit combination is disposed at a position of each first partition control signal line close to the second end, so that a voltage difference between a control signal of a 1 st row of pixels and a control signal of a last row of pixels of the pixel screen can be reduced, thereby improving a display effect.

In a possible design, line lengths from start ends to end ends of the p first partition control signal lines are the same.

In this design, because the line lengths from the start ends to the end ends of the p first partition control signal lines are the same, differences in the signal lines and parasitic capacitance load can be reduced, to eliminate a difference between output pulse signals of the first GOA circuit.

In a possible design, the p first partition control signal lines are coupled to the plurality of first GOA circuits through a first conductive layer and a second conductive layer of a substrate of the drive circuit, the start ends of the p first partition control signal lines are located at the first conductive layer, the second conductive layer and the first conductive layer are disposed opposite to each other, and the first conductive layer is connected to the second conductive layer through a connection hole; and a plurality of overlapping capacitors further exist on the p first partition control signal lines, the plurality of overlapping capacitors are formed by overlapping the first conductive layer and the second conductive layer, and a same quantity of overlapping capacitors exist between any adjacent connection holes on the p first partition control signal lines.

In this design, the p first partition control signal lines are distributed at different conductive layers, and a same quantity of overlapping capacitors exist between any adjacent connection holes on the p first partition control signal lines, so that the p first partition control signal lines have a same impedance, and a difference between output pulse signals of the first GOA circuit can be eliminated.

According to a second aspect, an embodiment of this application provides a driving method. The driving method is applied to a drive circuit. The drive circuit includes a plurality of first gate driver on array GOA circuits and p first partition control signal lines, p is an integer greater than or equal to 2, the plurality of first GOA circuits are sequentially cascaded, the plurality of first GOA circuits include n first GOA circuit combinations, n is an integer greater than or equal to p, and first GOA circuits in each first GOA circuit combination are sequentially cascaded; and a partition control end of each first GOA circuit in a $(px+y)^{th}$ first GOA circuit combination in the n first GOA circuit combinations is coupled to a $y^{th}$ first partition control signal line in the p first partition control signal lines, x is an integer greater than or equal to 0 and less than or equal to (n-y)/p, and y is an integer greater than or equal to 1 and less than or equal to p. The method includes: controlling the first GOA circuit to output a pulse signal; and controlling a level of the first partition control signal line to control a level of the pulse signal of the first GOA circuit.

For beneficial effect of the second aspect, refer to the descriptions of the first aspect.

In a possible design, when the first partition control signal line outputs a high level, the pulse signal of the first GOA circuit is at a high level, or when the first partition control signal line outputs a low level, the pulse signal of the first GOA circuit is at a low level.

According to a third aspect, an embodiment of this application provides a display system, including the drive circuit in the first aspect and a display circuit. The drive circuit is configured to transmit a pulse signal to the display circuit, and the display circuit is configured to display an image based on the pulse signal.

According to a fourth aspect, an embodiment of this application provides an electronic device, including a printed circuit board and the drive circuit in the first aspect. The drive circuit is electrically connected to the printed circuit board.

According to a fifth aspect, an embodiment of this application provides a computer-readable storage medium, including computer instructions. When the computer instructions are run on an electronic device, the electronic device is enabled to perform the driving method in any one of the foregoing aspects and the possible implementations.

According to a sixth aspect, an embodiment of this application provides a computer program product. When the computer program product runs on a computer or a processor, the computer or the processor is enabled to perform the driving method in any one of the foregoing aspects and the possible implementations.

According to a seventh aspect, an embodiment of this application provides a system. The system may include a wireless access device and at least one electronic device in any possible implementation of any one of the foregoing aspects. The electronic device and the wireless access device may perform the driving method in any one of the foregoing aspects and the possible implementations.

It may be understood that any drive circuit, display system, electronic device, computer-readable storage medium, computer program product, or the like provided above may be used in the corresponding method provided above. Therefore, for beneficial effect that can be achieved by the drive circuit, display system, electronic device, computer-readable storage medium, computer program product, or the like, refer to the beneficial effect in the corresponding method. Details are not described herein again.

These aspects or other aspects in this application are more concise and comprehensible in the following descriptions.

## BRIEF DESCRIPTION OF DRAWINGS

FIG. 1 is a diagram of a circuit structure of a GOA circuit according to an embodiment of this application;
FIG. 2 is a circuit diagram of four stages of GOA circuits according to an embodiment of this application;
FIG. 3 is a sequence diagram of four stages of GOA circuits according to an embodiment of this application;
FIG. 4 is a diagram of a structure of a display according to an embodiment of this application;
FIG. 5 is a circuit diagram of a drive circuit according to an embodiment of this application;
FIG. 6 is a diagram of a drive circuit including eight stages of first GOA circuits according to an embodiment of this application;
FIG. 7 is a sequence diagram of a drive circuit including eight stages of first GOA circuits according to an embodiment of this application;
FIG. 8 is a diagram of a partition whose partitioning precision is 2 according to an embodiment of this application;
FIG. 9 is a diagram of a relationship between a first partition control signal line, a pulse signal width, and a partitioning precision according to an embodiment of this application;
FIG. 10 is a diagram and a sequence diagram of a drive circuit including 16 stages of first GOA circuits according to an embodiment of this application;
FIG. 11 is a diagram and a sequence diagram of a drive circuit including 24 stages of first GOA circuits according to an embodiment of this application;
FIG. 12 is a diagram and a sequence diagram of a drive circuit including 18 stages of first GOA circuits according to an embodiment of this application;
FIG. 13 is a circuit diagram of another drive circuit according to an embodiment of this application;
FIG. 14 is a sequence diagram of another drive circuit according to an embodiment of this application;
FIG. 15 is a circuit diagram of still another drive circuit according to an embodiment of this application;
FIG. 16 is a sequence diagram of still another drive circuit according to an embodiment of this application;

FIG. 17 is a circuit diagram of still another drive circuit according to an embodiment of this application;

FIG. 18 is a sequence diagram of still another drive circuit according to an embodiment of this application;

FIG. 19 is a circuit diagram of still another drive circuit according to an embodiment of this application;

FIG. 20 is a circuit diagram of still another drive circuit according to an embodiment of this application;

FIG. 21 is a circuit diagram of still another drive circuit according to an embodiment of this application;

FIG. 22 is a circuit diagram of still another drive circuit according to an embodiment of this application;

FIG. 23 is a circuit diagram of still another drive circuit according to an embodiment of this application;

FIG. 24 is a diagram of a distribution of p first partition control signal lines according to an embodiment of this application;

FIG. 25 is a diagram of another distribution of p first partition control signal lines according to an embodiment of this application;

FIG. 26 is a flowchart of a driving method according to an embodiment of this application; and

FIG. 27 is a diagram of a structure of a display system according to an embodiment of this application.

## DESCRIPTION OF EMBODIMENTS

For ease of understanding, some concepts related to embodiments of this application are described for reference by using examples. Details are as follows:

An LTPO technology is a technical solution for a TFT backplane on an OLED screen, and supports adaptive adjustment of a refresh rate of the OLED screen to resolve a problem of power consumption of the screen. The LTPO technology is a combination of a mainstream low-temperature polysilicon (low-temperature polysilicon, LTPS) technology and indium gallium zinc oxide (indium gallium zinc oxide, IGZO) solution of the OLED screen, and can achieve a minimum screen refresh rate of 1 Hz, and a lower refresh rate brings lower power consumption, thereby saving a large amount of power.

The following describes the technical solutions in embodiments of this application with reference to the accompanying drawings in embodiments of this application. In descriptions in embodiments of this application, unless otherwise specified, "/" means "or". For example, A/B may represent A or B. In this specification, "and/or" describes only an association relationship for describing associated objects and represents that three relationships may exist. For example, A and/or B may represent the following three cases: Only A exists, both A and B exist, and only B exists. In addition, in the descriptions in embodiments of this application, "a plurality of" means two or more.

The terms "first" and "second" mentioned below are merely intended for a purpose of description, and shall not be understood as an indication or implication of relative importance or implicit indication of the number of indicated technical features. Therefore, a feature limited by "first" or "second" may explicitly or implicitly include one or more features. In the descriptions in embodiments, unless otherwise specified, "a plurality of" means two or more.

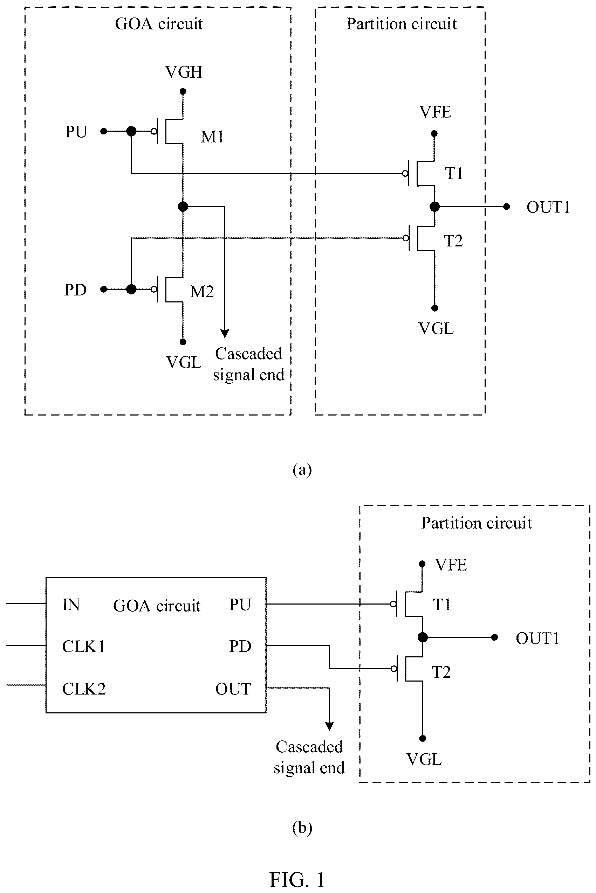

Currently, in an existing partitioning solution, a partition circuit is added to a GOA circuit, and a circuit structure is shown in FIG. 1. It may be understood that most circuit connections are omitted in FIG. 1, and the circuit connections may include a plurality of forms, which are not listed one by one herein. (a) in FIG. 1 shows a GOA circuit and a partition circuit. The GOA circuit mainly shows a coupling relationship between two TFTs, and the two TFTs are respectively M1 and M2. A drain of M1 inputs a high level (voltage high, VGH), a source of M1 is coupled to a cascaded signal end, and a gate of M1 is coupled to a pull-up (pull up, PU) node. The cascaded signal end is configured to be coupled to a signal input end of a next-stage GOA circuit. A source of M2 inputs a low level (voltage low, VGL), a drain of M2 is coupled to a cascaded signal end, and a gate of M2 is coupled to a pull-down (pull down, PD) node. (b) in FIG. 1 shows an integrated diagram and a partition circuit of a GOA circuit. The GOA circuit includes an input end (input, IN), a clock signal end (clock, CLK) (including CLK1 and CLK2), a PU node, a PD node, and an output end (output, OUT).

An operating principle of the GOA circuit is as follows: When the GOA circuit needs to output a high-level pulse signal, the PU node is set to a low level, and the PD node is set to a high level. When the GOA circuit needs to output a low-level pulse signal, the PD node is set to a low level, and the PU node is set to a high level. To improve a capability of the GOA circuit in outputting a low-level pulse signal, a level of the PD node is set to a level lower than VGL by using a capacitive coupling principle.

In addition, the partition circuit includes two TFTs: T1 and T2. One end of a source/drain of T1 is coupled to a partition control signal line (which is represented by VFE in FIG. 1 and in subsequent figures). That is, one end of the source/drain of T1 may be understood as a partition control end, the other end of the source/drain of T1 outputs a pulse signal (which is represented by OUT1 in FIG. 1), and a gate of T1 is coupled to the PU node. One end of a source/drain of T2 inputs VGL, the other end of the source/drain of T2 is an output end (OUT), and a gate of T2 is coupled to the PD node.

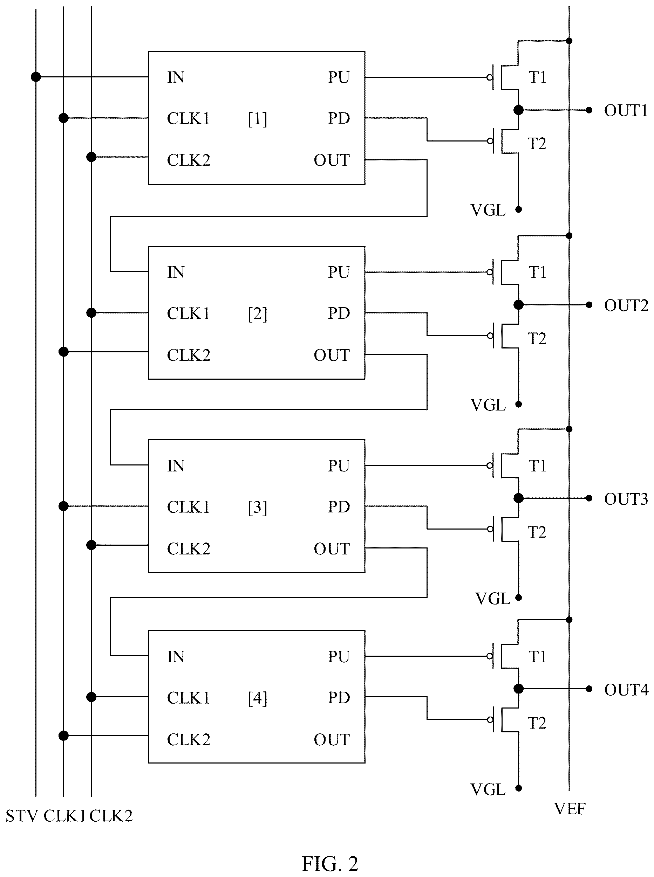

FIG. 2 shows four stages of GOA circuits and corresponding partition circuits. The four stages of GOA circuits are respectively GOA1, GOA2, GOA3, and GOA4 (which are respectively represented by [1], [2], [3], and [4] in FIG. 2 and in subsequent figures). A start-of-frame signal line (start voltage, STV) is coupled to an input end (IN) of GOA1. A CLK1 signal line and a CLK2 signal line are respectively coupled to corresponding GOA circuits in an alternating coupling manner at an odd-even level. For example, CLK1 is coupled to CLK1 of GOA1, CLK2 is coupled to CLK2 of GOA1, CLK1 is coupled to CLK2 of GOA2, and CLK2 is coupled to CLK1 of GOA2. In addition, all stages of GOA circuit are sequentially cascaded. To be specific, an output end (OUT) of each stage of GOA circuit is coupled to an input end (IN) of a next stage of GOA circuit, and a partition control signal line (VFE) uses only one signal line, and is coupled to a partition control end of each stage of GOA circuit.

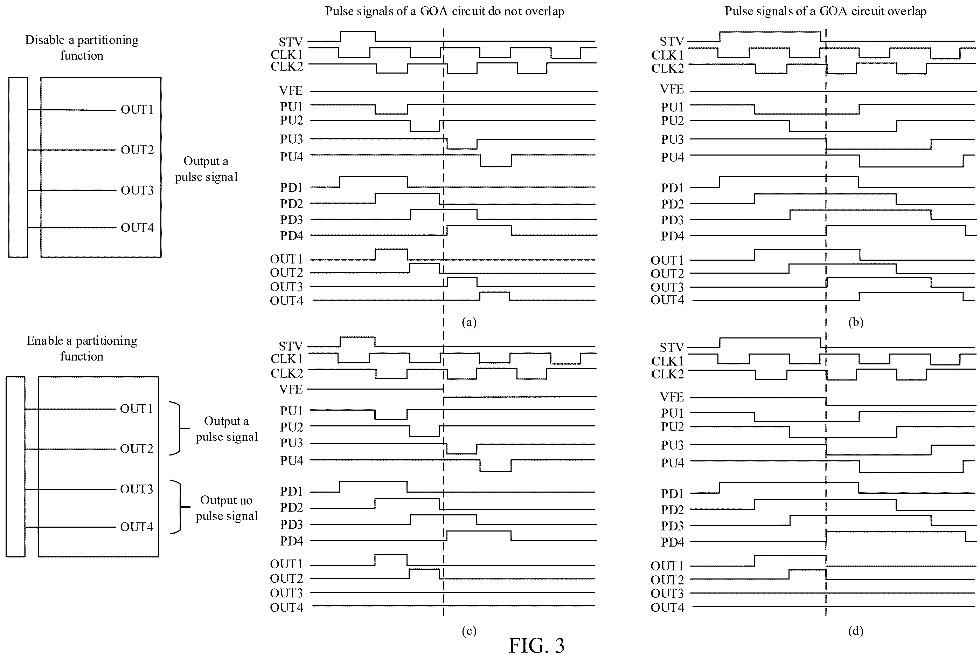

A sequence diagram of the four stages of GOA circuits shown in FIG. 2 is shown in FIG. 3. The four stages of GOA circuits include pulse signals OUT1, OUT2, OUT3, and OUT4. FIG. 3 separately shows cases of whether a partitioning function is disabled and whether pulse signals overlap. Disabling the partitioning function is that all the pulse signals are normally output, and enabling the partitioning function is that OUT1 and OUT2 are normally output, and OUT3 and OUT4 are not output. (a) in FIG. 3 is a sequence diagram in which the partitioning function is disabled and the pulse signals do not overlap, (b) in FIG. 3 is a sequence diagram in which the partitioning function is disabled and the pulse signals overlap, (c) in FIG. 3 is a sequence diagram in which the partitioning function is enabled and the pulse signals do not overlap, and (d) in FIG. 3 is a sequence diagram in which the partitioning function is enabled and the pulse signals overlap.

As shown in (a) in FIG. 3, in a case in which the pulse signals do not overlap, if the partitioning function needs to be disabled, only a partitioning control signal VFE needs to be set to VGH. As shown in (c) in FIG. 3, in a case in which the pulse signals do not overlap, if the partitioning function needs to be enabled, a partition control signal VFE is switched from VGH to VGL after OUT2 is output and before OUT3 is output. In this case, because the pulse signals of OUT1 and OUT2 have been output, OUT1 and OUT2 are not affected. In addition, output time nodes of OUT3 and OUT4 are after switching of the partition control signal VFE. Therefore, when OUT3 and OUT4 are output, because the partition control signal VFE is set to VGL, OUT3 and OUT4 still output low levels. In this way, a partition refresh function in which OUT1 and OUT2 are output normally, and OUT3 and OUT4 are not output can be implemented.

As shown in (b) in FIG. 3, in a case in which the pulse signals overlap, when the partitioning function needs to be disabled, only a partitioning control signal VFE needs to be set to VGH. As shown in (d) in FIG. 3, when the partitioning function needs to be enabled, a partition control signal VFE is switched from VGH to VGL after OUT2 is output and before OUT3 is output. Output time nodes of OUT3 and OUT4 are after switching of the partition control signal VFE. Therefore, when OUT3 and OUT4 are output, because the partition control signal is set to VGL, OUT3 and OUT4 still output low levels. However, when the partition control signal VFE is switched from VGH to VGL, OUT1 and OUT2 has not stopped outputting. Therefore, when the partition control signal is set to VGL, OUT1 and OUT2 are also switched to VGL with the partition control signal, and consequently pulse widths of OUT1 and OUT2 are inconsistent with required pulse widths. In addition, a longer overlapping area of pulse signals indicates a more serious problem of pulse width inconsistency. To be specific, for a GOA circuit with overlapping pulse signals, pulse widths of output pulse signals in different rows are inconsistent during partition refresh, and a partitioning function is not applicable to the GOA circuit with overlapping pulse signals.

Therefore, embodiments of this application provide a drive circuit. The drive circuit includes a plurality of first GOA circuits and a plurality of first partition control signal lines, and the plurality of first GOA circuits include a plurality of first GOA circuit combinations. Different levels are respectively provided for different first GOA circuit combinations by using a plurality of first partition control signal lines. Therefore, when pulse signals output by the first GOA circuits overlap, it can be ensured that a pulse signal of a first GOA circuit coupled to a current first partition control signal line is not affected by level switching of another first partition control signal line, and it is ensured that a width of the pulse signal is the same as an actual required width, thereby implementing a partitioning function.

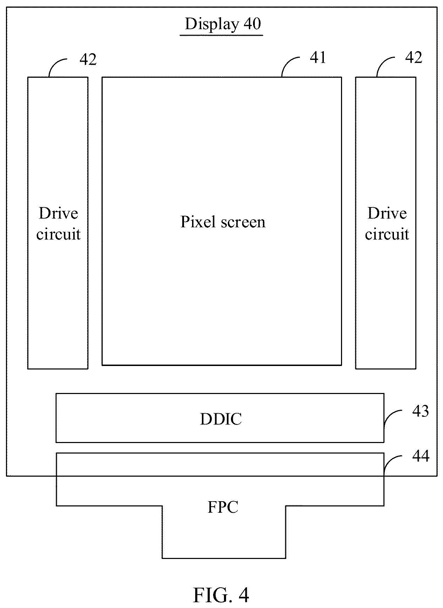

The drive circuit may be used in different systems or devices, for example, terminal devices, such as displays of the terminal devices such as a mobile phone terminal, a tablet terminal, a tablet computer, a notebook computer, an augmented reality (augmented reality, AR) device, a virtual reality (virtual reality, VR) device, and a vehicle-mounted terminal. As shown in FIG. 4, a display 40 may include a pixel screen 41 (pixel), a drive circuit 42, a display driver integrated circuit 43 (display driver integrated circuit, DDIC), and a flexible printed circuit 44 (flexible printed circuit, FPC). The pixel screen 41 is a display area of the display, and is configured to display image information. The drive circuit 42 is configured to provide a pulse signal for progressive scanning for the pixel screen 41. The flexible printed circuit 44 is configured to provide a coupling path for signal transmission between a drive system and the display 40. The display driver integrated circuit 43 is configured to receive a signal transmitted by the drive system, and transmit the signal to the pixel screen 41 and the drive circuit 42 according to a specific time sequence.

The following describes the drive circuit provided in embodiments of this application.

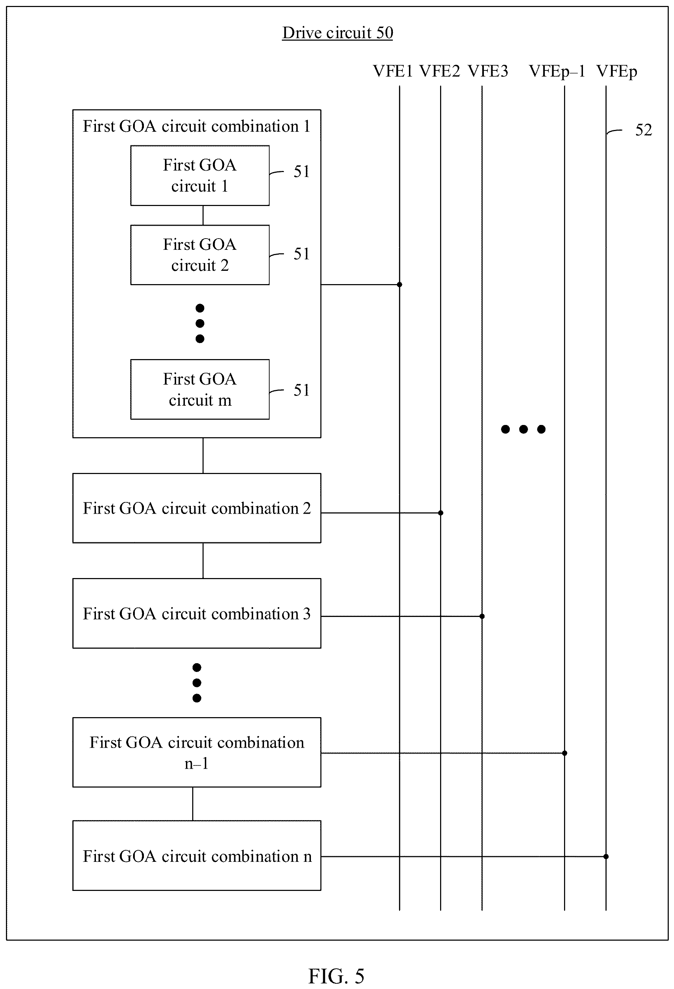

Embodiments of this application provide a drive circuit 50. As shown in FIG. 5, the drive circuit 50 includes a plurality of first GOA circuits 51 (which are respectively a first GOA circuit 1 to a first GOA circuit m) and p first partition control signal lines 52 (which are respectively VFE1 to VFEp), p is an integer greater than or equal to 2, the plurality of first GOA circuits 51 are sequentially cascaded, the plurality of first GOA circuits 51 include n first GOA circuit combinations (which are respectively a first GOA circuit combination 1 to a first GOA circuit combination n), n is an integer greater than or equal to p, and first GOA circuits in each first GOA circuit combination are sequentially cascaded; and each first GOA circuit 51 in a $(px+y)^{th}$ first GOA circuit combination in the n first GOA circuit combinations is coupled to a $y^{th}$ first partition control signal line in the p first partition control signal lines 52, x is an integer greater than or equal to 0 and less than or equal to $(n-y)/p$, and y is an integer greater than or equal to 1 and less than or equal to p.

A coupling manner between the first GOA circuit combination and the first partition control signal line 52 may be understood as alternating coupling. Specifically, using an example in which the quantity p of first partition control signal lines 52 is 2, values of y are 1 and 2, that is, each first GOA circuit 51 in a $(2x+1)^{th}$ first GOA circuit combination is coupled to a $1^{st}$ first partition control signal line 52, and each first GOA circuit 51 in a $(2x+2)^{th}$ first GOA circuit combination is coupled to a $2^{nd}$ first partition control signal line 52. More specifically, when x=0, each first GOA circuit 51 in a $1^{st}$ first GOA circuit combination is coupled to the $1^{st}$ first partition control signal line 52, and each first GOA circuit 51 in a $2^{nd}$ first GOA circuit combination is coupled to the $2^{nd}$ first partition control signal line 52. When x=1, each first GOA circuit 51 in a $3^{rd}$ first GOA circuit combination is coupled to the $1^{st}$ first partition control signal line 52, and each first GOA circuit 51 in a $4^{th}$ first GOA circuit combination is coupled to the $2^{nd}$ first partition control signal line 52. By analogy, the first GOA circuit combinations are alternately coupled to the $1^{st}$ first partition control signal line 52 and the $2^{nd}$ first partition control signal line 52 sequentially. It is assumed that the $1^{st}$ first partition control signal line 52 is A, and the $2^{nd}$ first partition control signal line 52 is B, that is, the first GOA circuit combinations are coupled to the first partition control signal lines 52 in a manner of "A-B-A-B...A-B".

The drive circuit 50 further includes a start-of-frame signal line 53, and a width of a pulse signal of the first GOA circuit 51 is determined by a width of the start-of-frame signal line. In addition, when the first partition control signal line 52 outputs a high level, the pulse signal of the first GOA circuit 51 is at a high level, or when the first partition control signal line 52 outputs a low level, the pulse signal of the first GOA circuit 51 is at a low level.

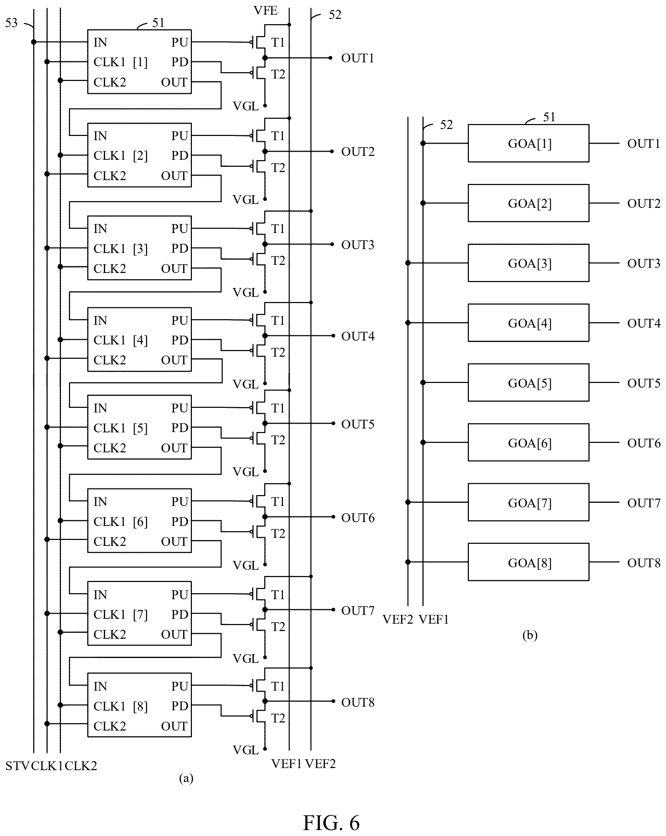

In an example, as shown in FIG. 6, (a) in FIG. 6 shows eight stages of first GOA circuits 51 (which are respectively GOA1 to GOA8), two first partition control signal lines 52 (which are respectively VFE1 and VFE2), and one start-of-frame signal line 53 (which is represented by STV in FIG. 6). (b) in FIG. 6 is an equivalent diagram of (a) in FIG. 6, and GOA[1] is used in (b) in FIG. 6 to represent a $1^{st}$ stage of first GOA circuit 51 and a partition circuit. The start-of-frame signal line 53 is coupled to an input end (IN) of GOA1, a CLK1 signal line and a CLK2 signal line are respectively coupled to corresponding first GOA circuits 51 in an alternating coupling manner at an odd-even level, and an output end (OUT) of each stage of first GOA circuit 51 is coupled to an input end (IN) of a next stage of first GOA circuit 51. A coupling manner between the start-of-frame signal line 53, the CLK1 signal line, and the CLK2 signal line in subsequent figures related to embodiments of this application is also correspondingly set, and details are not described subsequently. In addition, T2s of GOA1 to GOA8 are separately input to VGL, T1s of GOA1 and GOA2 are separately coupled to VFE1, T1s of GOA3 and GOA4 are separately coupled to VFE2, T1s of GOA5 and GOA6 are separately coupled to VFE1, and T1s of GOA7 and GOA8 are separately coupled to VFE2. In this way, the couplings are alternated.

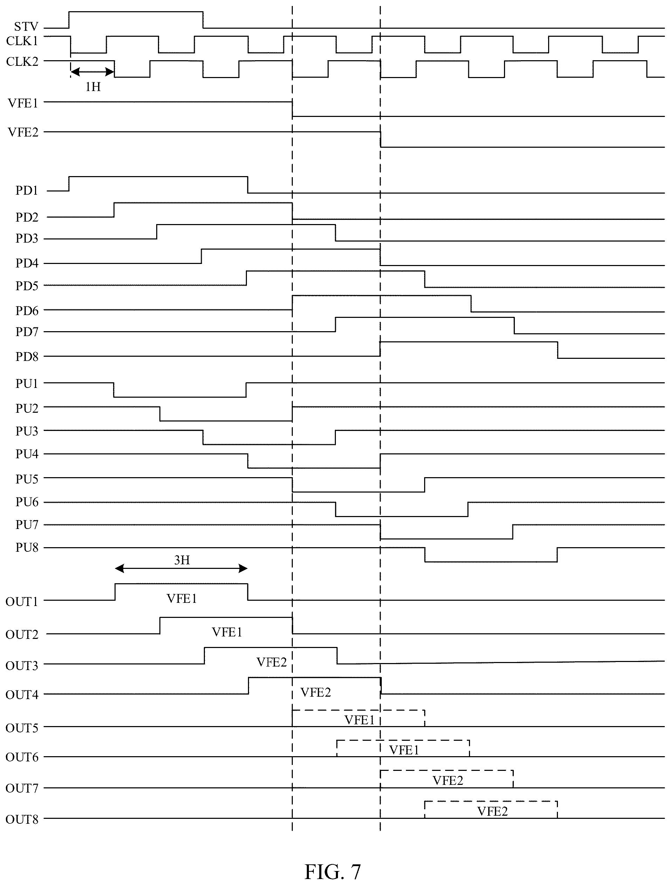

A sequence diagram of pulse signals of the eight stages of first GOA circuits 51 shown in FIG. 6 is shown in FIG. 7. The eight stages of first GOA circuits 51 include pulse signals OUT1 to OUT8. In the example in FIG. 7, GOA1 to GOA4 have a pulse signal, and GOA5 to GOA8 have no pulse signal. The four stages of first GOA circuits 51 of GOA1 to GOA4 may include GOA1 and GOA2 controlled by VFE1, and GOA3 and GOA4 controlled by VFE2. If GOA1 and GOA2 need to output pulse signals, PU nodes corresponding to GOA1 and GOA2 need to be set to VGL, corresponding PD nodes need to be set to VGH, and VFE1 needs to be set to VGH. Therefore, after T1 is started, a high level of VFE1 may be separately output to OUT1 and OUT2, to output the high-level pulse signals of GOA1 and GOA2. Similarly, if GOA3 and GOA4 need to output pulse signals, PU nodes corresponding to GOA3 and GOA4 need to be set to VGL, corresponding PD nodes need to be set to VGH, and VFE2 needs to be set to VGH. Therefore, after T1 is started, a high level of VFE2 may be separately output to OUT3 and OUT4, to output the high-level pulse signals of GOA3 and GOA4.

The four stages of first GOA circuits 51 of GOA5 to GOA8 may include GOA5 and GOA6 controlled by VFE1, and GOA7 and GOA8 controlled by VFE2. If GOA5 and GOA6 need to output pulse signals, PU nodes corresponding to GOA5 and GOA6 need to be set to VGL, corresponding PD nodes need to be set to VGH, and VFE1 needs to be set to VGL. Therefore, after T1 is started, a low level of VFE1 may be separately output to OUT5 and OUT6, to output the low-level pulse signals of GOA1 and GOA2. Similarly, if GOA7 and GOA8 need to output pulse signals, PU nodes corresponding to GOA7 and GOA8 need to be set to VGL, corresponding PD nodes need to be set to VGH, and VFE2 needs to be set to VGL. Therefore, after T1 is started, a low level of VFE2 may be separately output to OUT7 and OUT8, to output the low-level pulse signals of GOA7 and GOA8.

It can be learned from FIG. 7 that, when GOA5 and GOA6 output the low-level pulse signals, GOA1 and GOA2 controlled by VFE1 also output the high-level pulse signals. Therefore, when VFE1 is switched from VGH to VGL, output of the pulse signals of GOA1 and GOA2 is not affected. Similarly, when GOA7 and GOA8 output the low-level pulse signals, GOA3 and GOA4 controlled by VFE2 also output the high-level pulse signals. Therefore, the drive circuit provided in embodiments of this application can output overlapping pulse signals, to ensure that widths of the pulse signals are consistent with required pulse widths.

However, a width of the pulse signal of the first GOA circuit cannot be excessively wide. The width of the pulse signal shown in FIG. 7 is 3H, which can meet a requirement that the width of the pulse signal is consistent with a required pulse width. Time widths of a falling edge of the CLK1 signal line and a falling edge of CLK2 that are adjacent may be understood as 1H, 1H may be understood as a unit of a time width of a pulse signal, and a total time width of all pulse signals needs to be a multiple of 1H. If the width of the pulse signal of the first GOA circuit is greater than 3H, a problem of pulse width inconsistency still occurs. Therefore, a quantity of first partition control signal lines needs to be properly set to meet a partition refresh requirement.

A quantity of first GOA circuits 51 in the first GOA circuit combination is related to a quantity of first partition control signal lines 52 and the width of the pulse signal of the first GOA circuit 51.

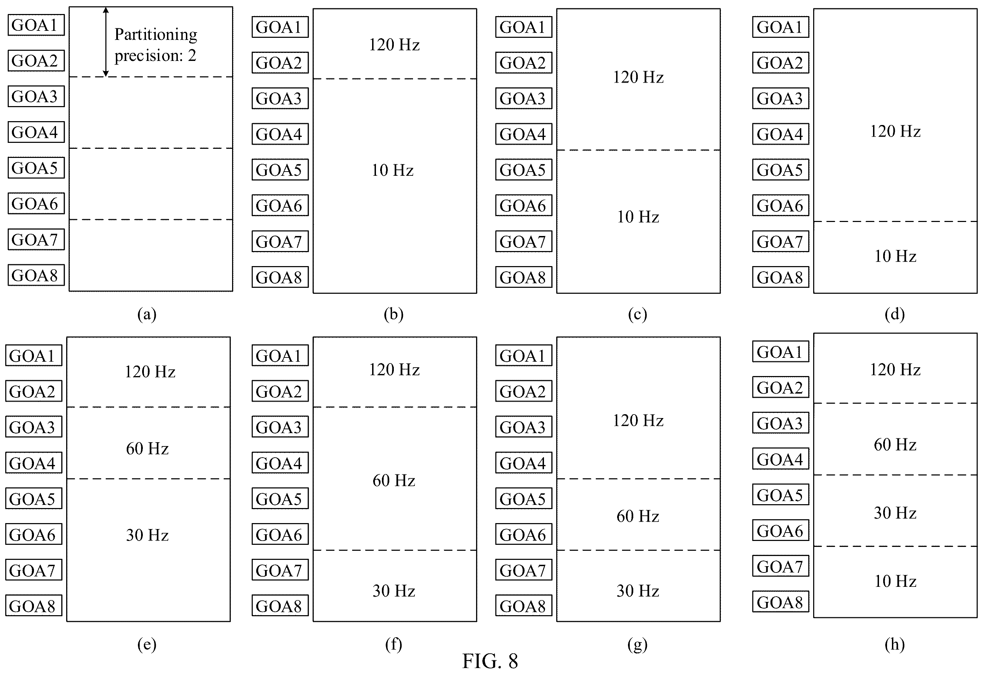

The quantity of first GOA circuits 51 in the first GOA circuit combination may be understood as a partitioning precision. In an example, FIG. 8 shows eight stages of first GOA circuit 51, where partitioning precision is 2, that is, one partition includes at least two first GOA circuits 51. (a) in FIG. 8 shows a diagram of a partition whose partitioning precision is 2. If the partitioning precision is 2, partition control is performed between GOA2 and GOA3, between GOA4 and GOA5, and between GOA6 and GOA7, but partition control cannot be performed between GOA1 and GOA2, between GOA3 and GOA4, between GOA5 and GOA6, and between GOA7 and GOA8. Three partitions are shown in (a) in FIG. 8, but whether to perform partitioning on all the partitions may be determined according to an actual requirement for displaying a picture.

For example, as shown in (b) in FIG. 8 to (h) in FIG. 8, (b) in FIG. 8 includes two partitions, where a partition including GOA1 and GOA2 uses a refresh frequency of 120 Hz, and a partition including GOA3 to GOA8 uses a refresh frequency of 10 Hz. (c) in FIG. 8 also includes two partitions, where a partition including GOA1 to GOA4 uses a refresh frequency of 120 Hz, and a partition including GOA5 to GOA8 uses a refresh frequency of 10 Hz. (d) in FIG. 8 also includes two partitions, where a partition including GOA1 to GOA6 uses a refresh frequency of 120 Hz, and a partition including GOA7 and GOA8 uses a refresh frequency of 10 Hz. (e) in FIG. 8 includes three partitions, where a partition including GOA1 and GOA2 uses a refresh frequency of 120 Hz, a partition including GOA3 and GOA4 uses a refresh frequency of 60 Hz, and a partition including GOA5 to GOA8 uses a refresh frequency of 30 Hz. (f) in FIG. 8 also includes three partitions, where a partition including GOA1 and GOA2 uses a refresh frequency of 120 Hz, a partition including GOA3 to GOA6 uses a refresh frequency of 60 Hz, and a partition including GOA7 and GOA8 uses a refresh frequency of 30 Hz. (g) in FIG. 8 also includes three partitions, where a partition including GOA1 to GOA4 uses a refresh frequency of 120 Hz, a partition including GOA5 and GOA6 uses a refresh frequency of 60 Hz, and a partition including GOA7 and GOA8 uses a refresh frequency of 30 Hz. (h) in FIG. 8 includes four partitions, where a partition including GOA1 and GOA2 uses a refresh frequency of 120 Hz, a partition including GOA3 and GOA4 uses a refresh frequency of 60 Hz, a partition including GOA5 and GOA6 uses a refresh frequency of 30 Hz, and a partition including GOA7 and GOA8 uses a refresh frequency of 10 Hz.

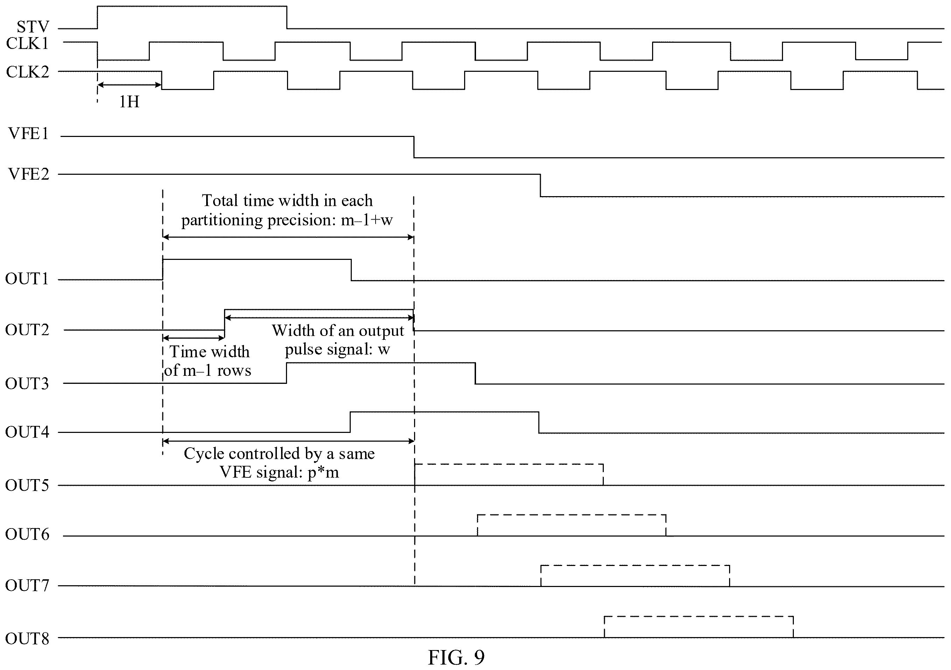

As shown in FIG. 9, a time width between a rising edge of OUT1 and a falling edge of OUT2 may be understood as a total time width in each partitioning precision. It is assumed that a pulse signal width of OUT1 or OUT2 is w (1H). A time width between the rising edge of OUT1 and a rising edge of OUT2 may be understood as a time width of the first m-1 rows, that is, m-1 (1H). Specifically, if m is 2, the time width of the first m-1 rows is 1H. Therefore, the total time width at each partitioning precision is a sum of the time width of the first m-1 rows and a width of a pulse signal in a last row, that is, m-1+w (1H). In addition, a cycle of receiving a same partition control signal is a product of a quantity of VFE signals and a partitioning precision, that is, p*m (1H). To avoid a problem that pulse widths of output overlapping pulse signals are inconsistent with required pulse widths, the cycle needs to be greater than or equal to the total time width in each partitioning precision, that is, $p*m \geq m-1+w$, and therefore $m \geq (w-1)/(p-1)$. For example, a width of a pulse signal of the first GOA circuit 51 shown in FIG. 6 is 3H, and a quantity of first partition control signal lines 52 is 2. Therefore, partitioning precision $m \geq 2$, that is, a minimum partitioning precision needs to be 2 to meet a partitioning requirement.

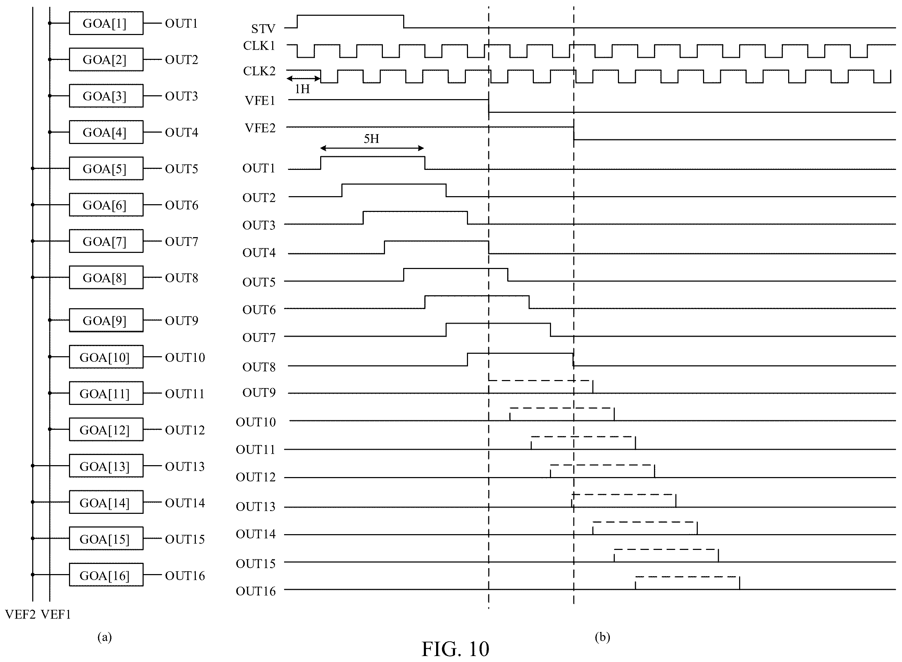

In an example, as shown in FIG. 10, (a) in FIG. 10 shows 16 stages of first GOA circuits 51 (which are respectively GOA1 to GOA16) and two first partition control signal lines 52 (which are respectively VFE1 and VFE2). (b) in FIG. 10 is a sequence diagram of (a) in FIG. 10, where a width of each pulse signal is 5H. Therefore, to meet a partitioning requirement, the partitioning precision m needs to be greater than or equal to 4. Therefore, in the circuit shown in FIG. 10, GOA1 to GOA4 are controlled by VFE1, GOA5 to GOA8 are controlled by VFE2, GOA9 to GOA12 are controlled by VFE1, and GOA13 to GOA16 are controlled by VFE2. It is assumed that VFE1 and VFE2 control GOA1 to GOA8 to output valid pulse signals, that is, output high-level pulse signals of OUT1 to OUT8, and control GOA9 to GOA16 to output no valid pulse signal, that is, output low-level pulse signals of OUT9 to OUT16. Therefore, VFE1 is switched from VGH to VGL after OUT4 is output. Because VFE1 is switched only after OUT4 is output, it can be ensured that high-level pulse signals of OUT1 to OUT4 are normally output, without affecting output of low-level pulse signals of OUT9 to OUT12. Similarly, VFE2 is switched from VGH to VGL after OUT8 is output, which ensures that high-level pulse signals of OUT5 to OUT8 are normally output, without affecting output of low-level pulse signals of OUT13 to OUT16.

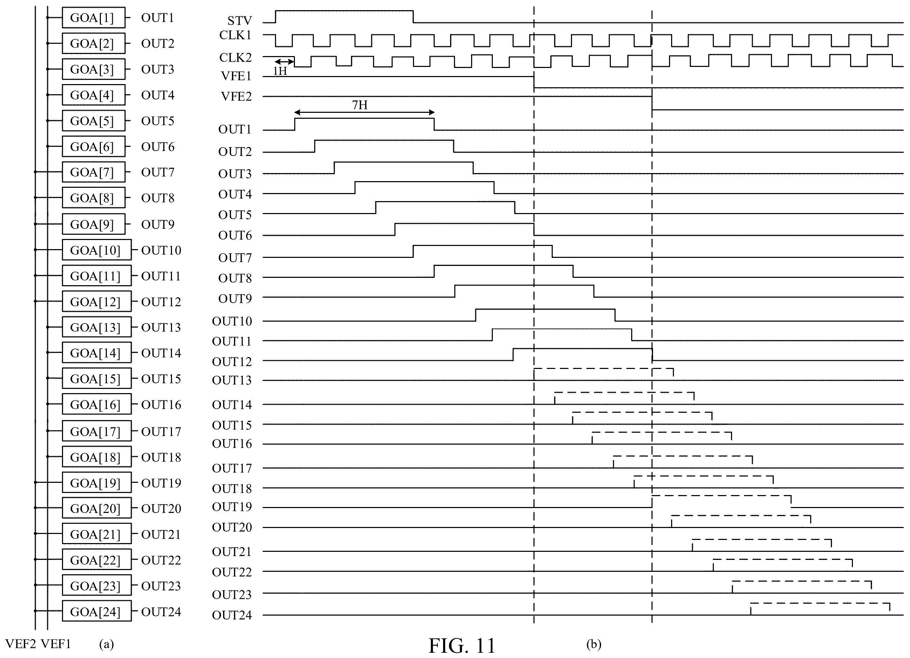

In another example, as shown in FIG. 11, (a) in FIG. 11 shows 24 stages of first GOA circuits 51 (which are respectively GOA1 to GOA24) and two first partition control signal lines 52 (which are respectively VFE1 and VFE2). (b) in FIG. 11 is a sequence diagram of (a) in FIG. 11, where a width of each pulse signal is 7H. Therefore, to meet a partitioning requirement, the partitioning precision m needs to be greater than or equal to 6. Therefore, in the circuit shown in FIG. 11, GOA1 to GOA6 are controlled by VFE1, GOA7 to GOA12 are controlled by VFE2, GOA13 to GOA18 are controlled by VFE1, and GOA19 to GOA24 are controlled by VFE2. It is assumed that VFE1 and VFE2 control GOA1 to GOA12 to output valid pulse signals, that is, output high-level pulse signals of OUT1 to OUT12, and control GOA13 to GOA24 to output no valid pulse signal, that is, output low-level pulse signals of OUT13 to OUT24. Therefore, VFE1 is switched from VFH to VGL after OUT6 is output. Because VFE1 is switched only after OUT6 is output, it can be ensured that high-level pulse signals of OUT1 to OUT6 are normally output, without affecting output of low-level pulse signals of OUT13 to OUT18. Similarly, VFE2 is switched from VGH to VGL after OUT12 is output, which ensures that high-level pulse signals of OUT7 to OUT12 are normally output, without affecting output of low-level pulse signals of OUT19 to OUT24.

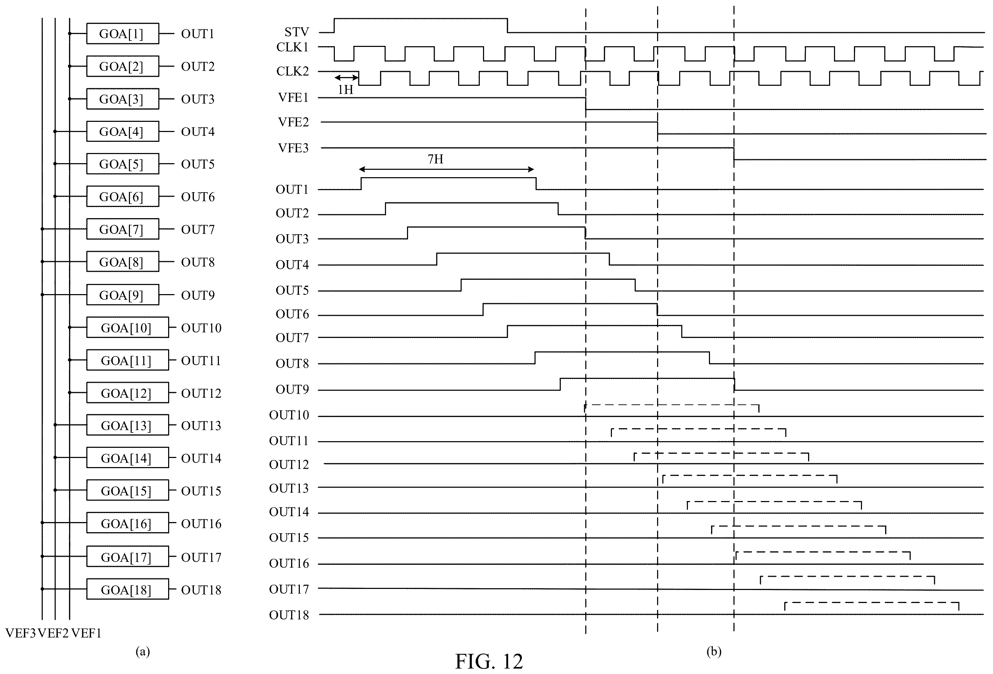

In still another example, as shown in FIG. 12, (a) in FIG. 12 shows 18 stages of first GOA circuits 51 (which are respectively GOA1 to GOA18) and three first partition control signal lines 52 (which are respectively VFE1, VFE2, and VFE3). (b) in FIG. 12 is a sequence diagram of (b) in FIG. 11, where a width of each pulse signal is 7H. Therefore, to meet a partitioning requirement, the partitioning precision m needs to be greater than or equal to 3. Therefore, in the circuit shown in FIG. 12, GOA1 to GOA3 are controlled by VFE1, GOA4 to GOA6 are controlled by VFE2, GOA7 to GOA9 are controlled by VFE3, GOA10 to GOA12 are controlled by VFE1, GOA13 to GOA15 are controlled by VFE2, and GOA16 to GOA18 are controlled by VFE3. It is assumed that VFE1, VFE2, and VFE3 control GOA1 to GOA9 to output valid pulse signals, that is, output high-level pulse signals of OUT1 to OUT9, and control GOA10 to GOA18 to output no valid pulse signal, that is, output low-level pulse signals of OUT10 to OUT18. Therefore, VFE1 is switched from VFH to VGL after OUT3 is output. Because VFE1 is switched only after OUT3 is output, it can be ensured that high-level pulse signals of OUT1 to OUT3 are normally output, without affecting output of low-level pulse signals of OUT10 to OUT112. Similarly, VFE2 is switched from VGH to VGL after OUT6 is output, which ensures that high-level pulse signals of OUT4 to OUT6 are normally output, without affecting output of low-level pulse signals of OUT13 to OUT15. VFE3 is switched from VGH to VGL after OUT9 is output, which ensures that high-level pulse signals of OUT7 to OUT9 are normally output, without affecting output of low-level pulse signals of OUT16 to OUT18.

Therefore, in embodiments of this application, for overlapping pulse signals, different levels are respectively provided for different first GOA circuit combinations by using a plurality of first partition control signal lines, which can ensure that a pulse signal of a first GOA circuit 51 of a current first partition control signal line is not affected by level switching of another first partition control signal line, and ensure that a width of the pulse signal is the same as an actual required width, thereby implementing a partitioning function.

In addition, to further reduce power consumption, for non-overlapping pulse signals, the drive circuit 50 provided in embodiments of this application may further reduce frequencies of a corresponding CLK1 signal line and CLK2 signal line when no pulse signal is output, to more effectively reduce power consumption.

Therefore, the drive circuit 50 may further include a second partition control signal line 54, a third partition control signal line 55, a plurality of control circuits 56, and a plurality of second GOA circuits 57. The plurality of second GOA circuits 57 are sequentially cascaded, the plurality of second GOA circuits include a plurality of second GOA circuit combinations, second GOA circuits in each second GOA circuit combination are sequentially cascaded, a quantity of second GOA circuit combinations is the same as a quantity of control circuits 56, control ends of the plurality of control circuits 56 are coupled to the second partition control signal line 54 and the third partition control signal line 55, a first end of each control circuit 56 in the plurality of control circuits 56 is coupled to the first GOA circuit combination, and a second end of each control circuit 56 in the plurality of control circuits 56 is coupled to a corresponding second GOA circuit combination.

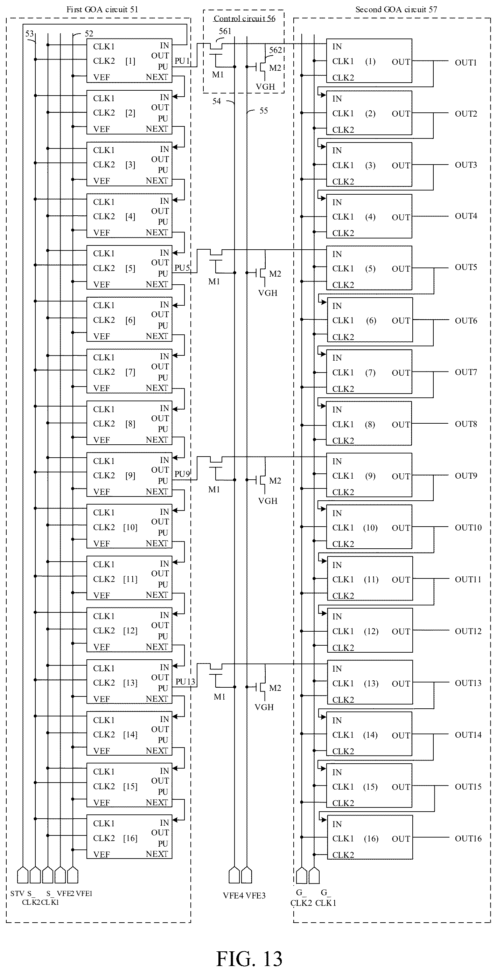

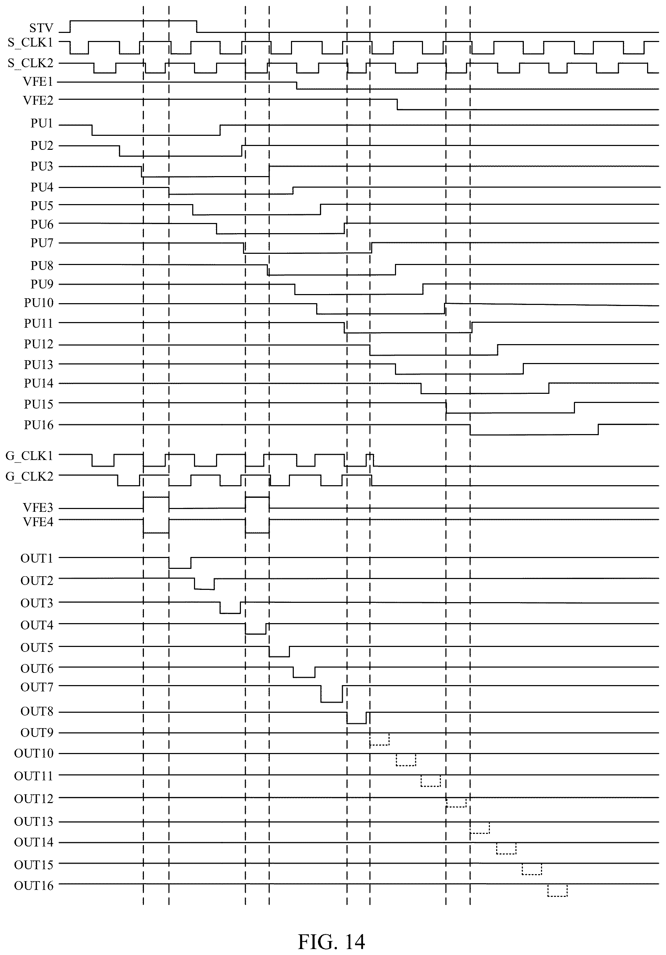

FIG. 13 shows four first GOA circuit combinations, four second GOA circuit combinations, and four control circuits 56. In addition, the circuit in FIG. 13 includes two first partition control signal lines 52 (which are represented by VFE1 and VFE2 in FIG. 13), a second partition control signal line 54 (which is represented by VFE4 in FIG. 14), and a third partition control signal line 55 (which is represented by VFE3 in FIG. 13). Clock signals of the first GOA circuit combinations are represented by S_CLK1 and S_CLK2, and clock signals of the second GOA circuit combinations are represented by G_CLK1 and G_CLK2. The control circuit 56 may include a first thin film transistor 561 (which is represented by M1 in FIG. 13) and a second thin film transistor 562 (which is represented by M2 in FIG. 13). A drain of the first thin film transistor 561 is coupled to the first end of the control circuit 56, a gate of the first thin film transistor 561 is coupled to the second partition control signal line 54 (which is represented by VFE4 in FIG. 4), and a source of the first thin film transistor 561 is coupled to the second end of the control circuit 56. A drain of the second thin film transistor 562 is coupled to a power output end (which is represented by VGH in FIG. 13), a gate of the second thin film transistor 562 is coupled to the third partition control signal line 55, and a source of the second thin film transistor 562 is coupled to the second end of the control circuit 56.

FIG. 14 is a sequence diagram of the circuit diagram shown in FIG. 13. PU1 to PU16 in the sequence diagram are respectively PU nodes of the first GOA circuits 51. It can be learned from FIG. 7 that PU1 to PU16 are low-level pulse signals with a row-by-row shift. It is assumed that, in the circuit diagram shown in FIG. 13, GOA1 to GOA8 in the second GOA circuit 57 output low-level pulse signals, and GOA9 to GOA16 in the second GOA circuit 57 output high-level pulse signals. When the PU1 node is at a low level, VFE3 is set to a high level, and VFE4 is set to a low level, that is, M1 is turned on, and M2 is turned off. The low level of the PU1 node is transmitted to an input end of a $1^{st}$ second GOA circuit 57 through M1, and is used as a first-stage valid input pulse of the second GOA circuit combination. In this case, G_CLK1 is at a low level, and the valid input pulse may be sent to the $1^{st}$ second GOA circuit 57. When G_CLK2 is at a low level, an output end of the $1^{st}$ second GOA circuit 57 outputs a valid low-level pulse signal. An output end of a previous second GOA circuit 57 provides a valid input pulse for an input end of another second GOA circuit 57 in the partitioning precision. Because a pulse signal of the $1^{st}$ second GOA circuit 57 is a low-level pulse signal, a $2^{nd}$ second GOA circuit 57 also receives a low-level valid signal, and an output end of a last second GOA circuit 57 may also output a valid low-level pulse signal. Similarly, a $3^{rd}$ second GOA circuit 57 and a $4^{th}$ second GOA circuit 57 in the same partition may also output valid low-level pulse signals.

When PU5 is at a low level, VFE3 is set to a high level, and VFE4 is set to a low level, that is, M1 is turned on, and M2 is turned off. The low level of the PU5 node is transmitted to an input end of a $5^{th}$ second GOA circuit 57 through M1, and is used as a valid input pulse of the $5^{th}$ second GOA circuit 57. In this case, G_CLK1 is at a low level, and the valid input pulse may be sent to the $5^{th}$ second GOA circuit 57. When G_CLK2 is at a low level, an output end of the $5^{th}$ second GOA circuit 57 outputs a valid low-level pulse signal. Similarly, an output end of a previous second GOA circuit 57 provides valid input pulses for input ends of a $6^{th}$ second GOA circuit 57 to an $8^{th}$ second GOA circuit 57 in the same partition, and may also output a valid low-level pulse signal.

When PU9 is at a low level, VFE3 is set to a low level, and VFE4 is set to a high level, that is, M1 is turned on, and M2 is turned off. A high level of M2 is transmitted to an input end of a $9^{th}$ second GOA circuit 57, and is used as a high-level signal input of the $9^{th}$ second GOA circuit 57. In this case, G_CLK1 is at a low level, and the high-level signal may be sent to the $9^{th}$ second GOA circuit 57. When G_CLK2 is at a low level, an output end of the $9^{th}$ second GOA circuit 57 outputs a high-level pulse signal.

Similarly, an output end of a previous second GOA circuit 57 provides high-level signals for input ends of a $10^{th}$ second GOA circuit 57 to a $12^{th}$ second GOA circuit 57 in the same partition, and may also output a high-level pulse signal.

When PU13 is at a low level, VFE3 is set to a low level, and VFE4 is set to a high level, that is, M1 is turned on, and M2 is turned off. A high level of M2 is transmitted to an input end of a $13^{th}$ second GOA circuit 57, and is used as a high-level signal input of the $13^{th}$ second GOA circuit 57. In this case, G_CLK1 is at a low level, and the high-level signal may be sent to the $13^{th}$ second GOA circuit 57. When G_CLK2 is at a low level, an output end of the $13^{th}$ second GOA circuit 57 outputs a high-level pulse signal. Similarly, an output end of a previous second GOA circuit 57 provides high-level signals for input ends of a $14^{th}$ second GOA circuit 57 to a $16^{th}$ second GOA circuit 57 in the same partition, and may also output a high-level pulse signal.

Therefore, because the valid pulse of the $1^{st}$ second GOA circuit 57 in each partition is provided by the PU node in the corresponding first GOA circuit 51, in a time period from the $9^{th}$ second GOA circuit 57 to the $16^{th}$ second GOA circuit 57 that output no valid signal, G_CLK1 and G_CLK2 may be set to a low level, to reduce power consumption in the time period.

It may be understood that, as shown in the circuit in FIG. 14, the signal of the PU1 node of the $1^{st}$ first GOA circuit 51 is transmitted to the $1^{st}$ second GOA circuit 57, but the signal of the PU2 node of the $2^{nd}$ first GOA circuit 51 may alternatively be transmitted to the $1^{st}$ second GOA circuit 57. This is not limited in this application. In addition, M1 is not limited to transmitting a signal of the PU node of the first GOA circuit 51, and may alternatively be transmitting another node signal having a valid low-level pulse that is in the first GOA circuit 51 and that has a row-by-row shift.

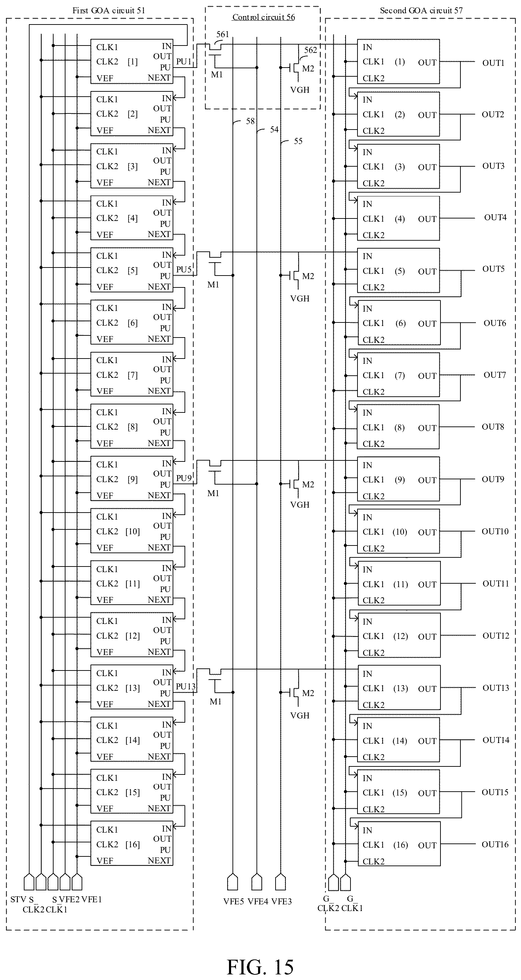

As shown in FIG. 15, the drive circuit 50 may further include a fourth partition control signal line 58 (which is represented by VFE5 in FIG. 15). A gate of the first thin film transistor 561 of a $(2i-1)^{th}$ control circuit 56 in the plurality of control circuits 56 is coupled to the second partition control signal line 54, i is a positive integer, and a gate of the first thin film transistor 561 of a $(2i)^{th}$ control circuit 56 in the plurality of control circuits 56 is coupled to the fourth partition control signal line 58. It may be understood that an odd quantity of control circuits 56 in the plurality of control circuits 56 are coupled to the second partition control signal line 54, and an even quantity of control circuits 56 in the plurality of control circuits 56 are coupled to the fourth partition control signal line 58. Specifically, FIG. 15 shows a total of four first GOA circuit combinations, four second GOA circuit combinations, and four control circuits 56. VFE4 and VFE5 jointly control a state of M1, and VFE3 controls a state of M2. $1^{st}$ M1 and $3^{rd}$ M1 are controlled by VFE4, and $2^{nd}$ M1 and $4^{th}$ M1 are controlled by VFE5.

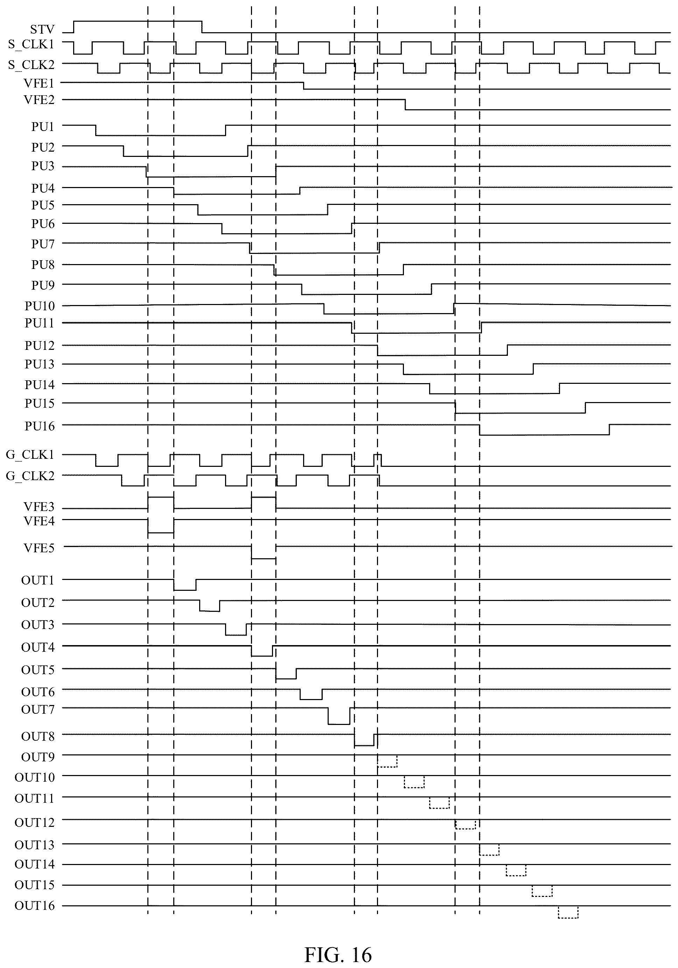

FIG. 16 is a sequence diagram of the circuit diagram shown in FIG. 15. It is assumed that, in the circuit diagram shown in FIG. 15, GOA1 to GOA8 in the second GOA circuit 57 output low-level pulse signals, and GOA9 to GOA16 in the second GOA circuit 57 output high-level pulse signals. When the PU1 node is at a low level, VFE3 is set to a high level, VFE4 is set to a low level, and VFE5 is set to a high level, that is, the 1st M1 and the 3rd M1 are turned on, the 2nd M1 and the 4th M1 are turned off, and M2 is turned off. The low level of the PU1 node is transmitted to an input end of a 1st second GOA circuit 57 through M1, and is used as a first-stage valid input pulse of the second GOA circuit combination. In this case, G_CLK1 is at a low level, and the valid input pulse may be sent to the 1st second GOA circuit 57. When G_CLK2 is at a low level, an output end of the 1st second GOA circuit 57 outputs a valid low-level pulse signal. An output end of a previous second GOA circuit 57 provides a valid input pulse for an input end of another second GOA circuit 57 in the partitioning precision. Because a pulse signal of the 1st second GOA circuit 57 is a low-level pulse signal, a 2nd second GOA circuit 57 also receives a low-level valid signal, and an output end of a last second GOA circuit 57 may also output a valid low-level pulse signal. Similarly, a 3rd second GOA circuit 57 and a 4th second GOA circuit 57 in the same partition may also output valid low-level pulse signals.

When the PU5 node is at a low level, VFE3 is set to a high level, VFE4 is set to a high level, and VFE5 is set to a low level, that is, the 2nd M1 and the 4th M1 are turned on, the 1st M1 and the 3rd M1 are turned off, and M2 is turned off. The low level of the PU5 node is transmitted to an input end of a 5th second GOA circuit 57 through M1, and is used as a valid input pulse of the 5th second GOA circuit 57. In this case, G_CLK1 is at a low level, and the valid input pulse may be sent to the 5th second GOA circuit 57. When G_CLK2 is at a low level, an output end of the 5th second GOA circuit 57 outputs a valid low-level pulse signal. Similarly, an output end of a previous second GOA circuit 57 provides valid input pulses for input ends of a 6th second GOA circuit 57 to an 8th second GOA circuit 57 in the same partition, and may also output a valid low-level pulse signal.

When PU9 is at a low level, VFE3 is set to a low level, VFE4 is set to a high level, and VFE5 is set to a high level, that is, M1 is turned off, and M2 is turned on. A high level of M2 is transmitted to an input end of a 9th second GOA circuit 57, and is used as a high-level signal input of the 9th second GOA circuit 57. In this case, G_CLK1 is at a low level, and the high-level signal may be sent to the 9th second GOA circuit 57. When G_CLK2 is at a low level, an output end of the 9th second GOA circuit 57 outputs a high-level pulse signal. Similarly, an output end of a previous second GOA circuit 57 provides high-level signals for input ends of a 10th second GOA circuit 57 to a 12th second GOA circuit 57 in the same partition, and may also output a high-level pulse signal.

When PU13 is at a low level, VFE3 is set to a low level, VFE4 is set to a high level, and VFE5 is set to a high level, that is, M1 is turned off, and M2 is turned on. A high level of M2 is transmitted to an input end of a 13th second GOA circuit 57, and is used as a high-level signal input of the 13th second GOA circuit 57. In this case, G_CLK1 is at a low level, and the high-level signal may be sent to the 13th second GOA circuit 57. When G_CLK2 is at a low level, an output end of the 13th second GOA circuit 57 outputs a high-level pulse signal. Similarly, an output end of a previous second GOA circuit 57 provides high-level signals for input ends of a 14th second GOA circuit 57 to a 16th second GOA circuit 57 in the same partition, and may also output a high-level pulse signal.

Because signals of the PU nodes are overlapping pulse signals, signals of PU nodes in different rows overlap. For example, when the PU1 node is a valid low-level pulse signal, and the second partition control signal line 54 controls the 1st second GOA circuit 57 to output the pulse signal, if PU5 is also a low-level signal, the 5th second GOA circuit 57 may output a pulse signal by mistake. This case can be avoided by disposing the fourth partition control signal line 58 and cooperating with the second partition control signal line 54 to control output of the pulse signal of the second GOA circuit 57.

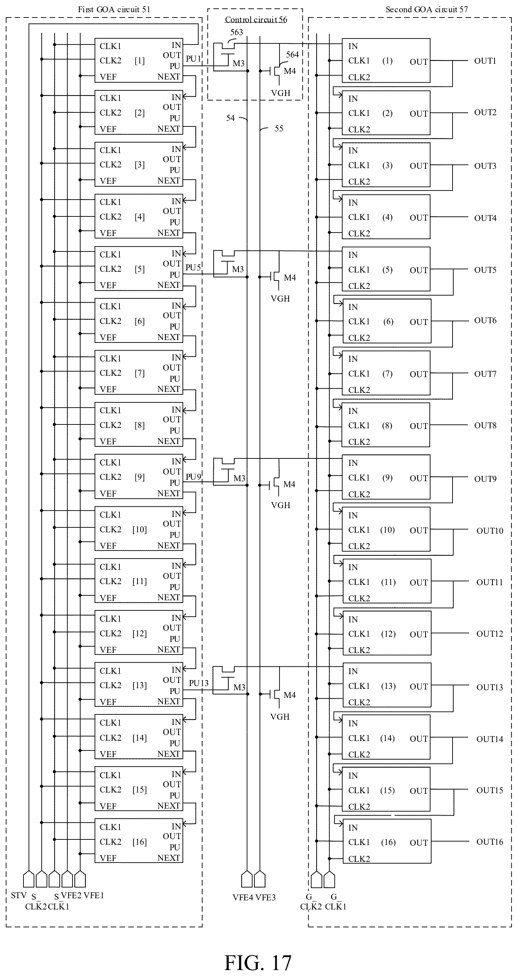

Optionally, FIG. 17 shows four first GOA circuit combinations, four second GOA circuit combinations, and four control circuits 56. The control circuit 56 may further include a third thin film transistor 563 (which is represented by M3 in FIG. 17) and a fourth thin film transistor (which is represented by M4 in FIG. 17). A drain of the third thin film transistor 563 is coupled to the second partition control signal line 54, a gate of the third thin film transistor 563 is coupled to the first end of the control circuit 56, and a source of the third thin film transistor 563 is coupled to the second end of the control circuit; and a drain of the fourth thin film transistor 564 is coupled to a power output end (which is represented by VGH in FIG. 17), a gate of the fourth thin film transistor 564 is coupled to the third partition control signal line 55, and a source of the fourth thin film transistor 564 is coupled to the second end of the control circuit 56.

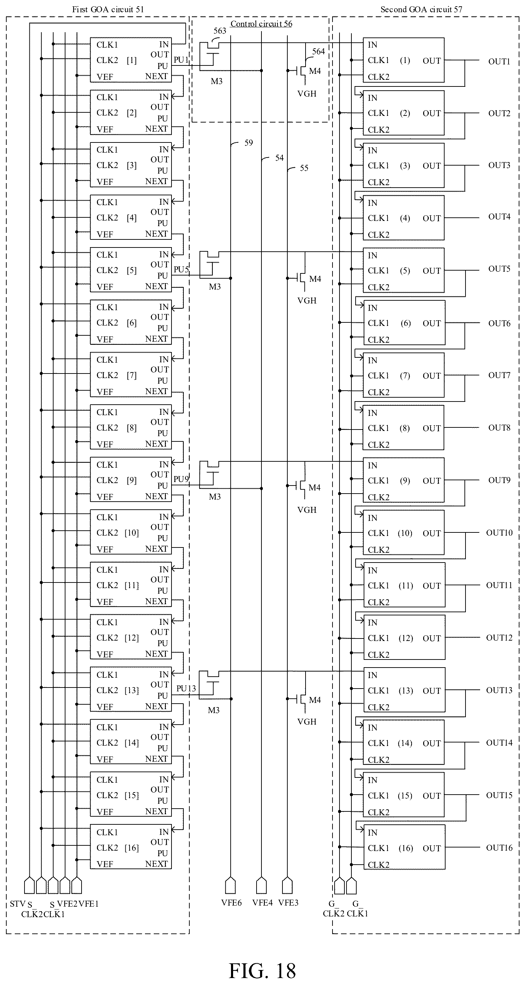

Optionally, as shown in FIG. 18, the drive circuit 50 may further include a fifth partition control signal line 59 (which is represented by VFE6 in FIG. 18), a drain of the third thin film transistor 563 of a (2j-1)th control circuit 56 in the plurality of control circuits 56 is coupled to the second partition control signal line 54, j is a positive integer, and a drain of the third thin film transistor 563 of a (2j)th control circuit 56 in the plurality of control circuits 56 is coupled to the fifth partition control signal line 59. It may be understood that an odd quantity of control circuits 56 in the plurality of control circuits 56 are coupled to the second partition control signal line 54, and an even quantity of control circuits 56 in the plurality of control circuits 56 are coupled to the fifth partition control signal line.

Compared with the circuit shown in FIG. 13 in which the level of the PU node in the first GOA circuit 51 is transmitted to the input end of the second GOA circuit 57, the circuit shown in FIG. 17 in which the level of VFE4 is transmitted to the input end of the second GOA circuit 57 has a same operating principle as the circuit shown in FIG. 13, and details are not described herein. In addition, an operating principle of the circuit shown in FIG. 18 is also the same as an operating principle of the circuit shown in FIG. 15, and details are not described herein.

In an example, it is assumed that a low level of the PU node is -20 V, a low level of VFE4 is -10 V, and a turn-on voltage of the thin film transistor is -2 V. If the thin film transistor uses the connection method shown in FIG. 13, a voltage of the input end of the second GOA circuit 57 is -8 V, or if the thin film transistor uses the connection method shown in FIG. 17, a voltage of the input end of the second GOA circuit 57 is -10 V. In this way, it can be ensured that the second GOA circuit 57 receives a valid pulse signal.

In an example, FIG. 13, FIG. 15, FIG. 17, and FIG. 18 are used to implement frequency reduction of a clock signal in a time period in which no valid pulse signal is output. However, for the 1st second GOA circuit 57 in each partition, only a valid pulse signal needs to be output, and therefore VFE3, VFE4, or VFE5 needs to switch a level. If there are an excessively large quantity of partitions, and a quantity of times of switching the partition control signal line increases accordingly, power consumption of the drive circuit increases.

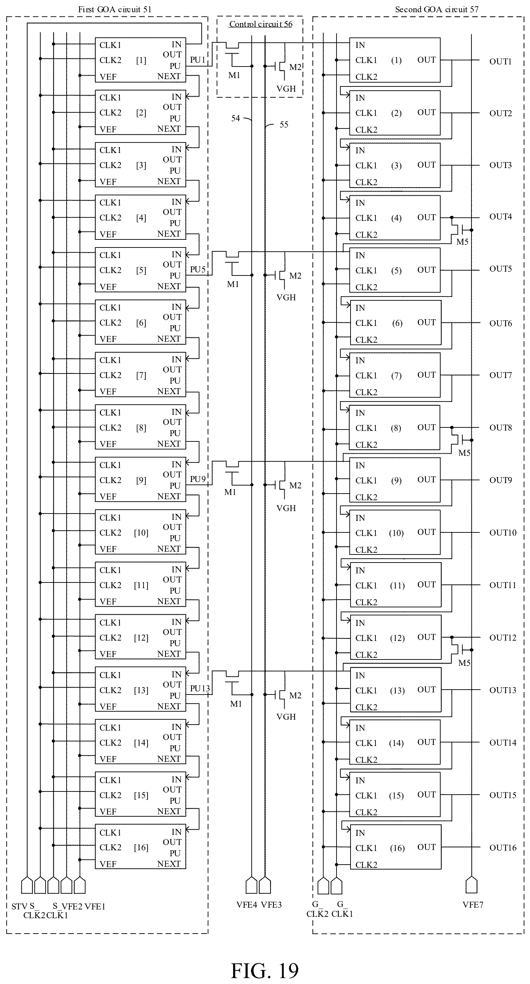

Therefore, embodiments of this application provide another drive circuit 50. As shown in FIG. 19, the drive circuit 50 may further include a plurality of fifth thin film transistors 510 (which are represented by M5 in FIG. 19) and a sixth partition control signal line 511 (which is represented by VFE7 in FIG. 19), a drain of the fifth thin film transistor 510 is coupled to an output end of a last second GOA circuit 57 in a second GOA circuit combination, a source of the fifth thin film transistor 510 is coupled to an input end of a 1st second GOA circuit 57 in a next second GOA circuit combination, and a gate of the fifth thin film transistor 510 is coupled to the sixth partition control signal line 511.

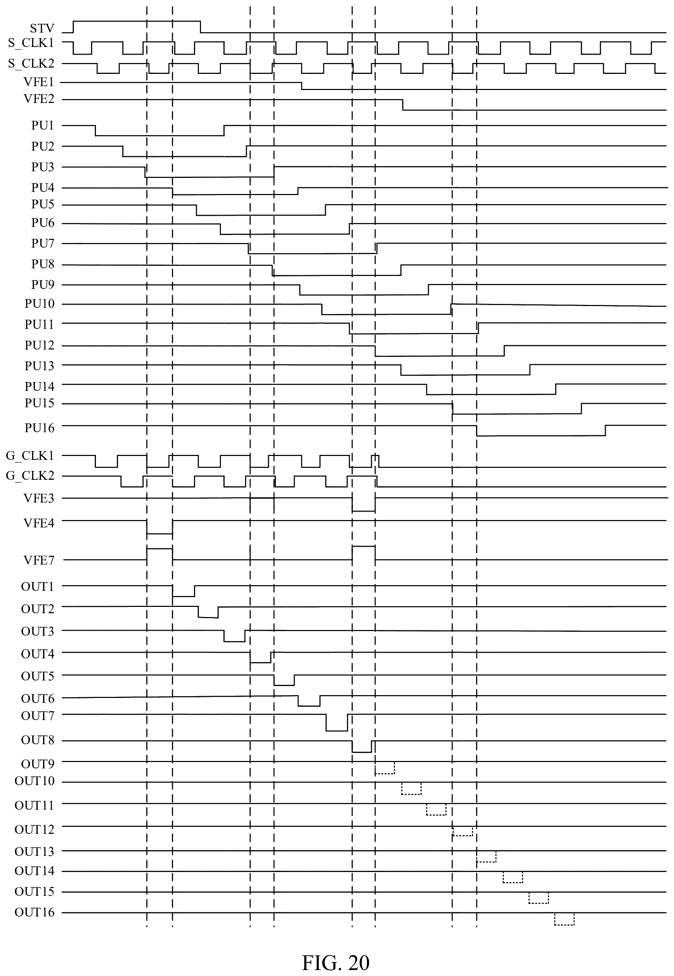

FIG. 20 is a sequence diagram of the circuit shown in FIG. 19. It is assumed that, in the circuit diagram shown in FIG. 19, GOA1 to GOA8 in the second GOA circuit 57 output low-level pulse signals, and GOA9 to GOA16 in the second GOA circuit 57 output high-level pulse signals. When the PU1 node is at a low level, VFE3 is set to a high level, VFE4 is set to a low level, and VFE7 is set to a high level, that is, M1 is turned on, and M2 and M5 are turned off. The low level of the PU1 node is transmitted to an input end of a 1st second GOA circuit 57 through M1, and is used as a first-stage valid input pulse of the second GOA circuit combination. In this case, G_CLK1 is at a low level, and the valid input pulse may be sent to the 1st second GOA circuit 57. When G_CLK2 is at a low level, an output end of the 1st second GOA circuit 57 outputs a valid low-level pulse signal. An output end of a previous second GOA circuit 57 provides a valid input pulse for an input end of another second GOA circuit 57 in the partitioning precision. Because a pulse signal of the 1st second GOA circuit 57 is a low-level pulse signal, a 2nd second GOA circuit 57 also receives a low-level valid signal, and an output end of a last second GOA circuit 57 may also output a valid low-level pulse signal. Similarly, a 3rd second GOA circuit 57 and a 4th second GOA circuit 57 in the same partition may also output valid low-level pulse signals.

When PU5 is at a low level, because the output of the 4th second GOA circuit 57 is a valid low-level pulse signal, VFE7 is set to a low level, and VFE3 and VFE4 are set to a high level, that is, a time sequence from the 2nd GOA circuit 57 to the 4th GOA circuit 57 is maintained. In this case, M5 is turned on, M1 and M2 are turned off, and the pulse signal of the 4th second GOA circuit 57 is transmitted to an input end of a 5th second GOA circuit 57 through M5. In this case, G_CLK1 is at a low level, and the valid input pulse may be sent to the 5th second GOA circuit 57. When G_CLK2 is at a low level, an output end of the 5th second GOA circuit 57 outputs a valid low-level pulse signal. Similarly, an output end of a previous second GOA circuit 57 provides valid input pulses for input ends of a 6th second GOA circuit 57 to an 8th second GOA circuit 57 in the same partition, and may also output a valid low-level pulse signal.

When PU9 is at a low level, because the output of the 8th second GOA circuit 57 is a valid low-level pulse signal, VFE7 is set to a low level, and VFE3 and VFE4 are set to a high level. In this case, M2 is turned on, and M1 and M5 are turned off. A high level of M2 is transmitted to an input end of a 9th second GOA circuit 57, and is used as a high-level signal input of the 9th second GOA circuit 57. In this case, G_CLK1 is at a low level, and the high-level signal may be sent to the 9th second GOA circuit 57. When G_CLK2 is at a low level, an output end of the 9th second GOA circuit 57 outputs a high-level pulse signal. Similarly, an output end of a previous second GOA circuit 57 provides high-level signals for input ends of a 10th second GOA circuit 57 to a 12th second GOA circuit 57 in the same partition, and may also output a high-level pulse signal.

When PU13 is at a low level, because the output of the 12th second GOA circuit 57 is a high-level pulse signal, VFE7 is set to a low level, and VFE3 and VFE4 are set to a high level, that is, M5 is turned on, and M1 and M2 are turned off. A high level of M2 is transmitted to an input end of a 13th second GOA circuit 57, and is used as a high-level signal input of the 13th second GOA circuit 57. In this case, G_CLK1 is at a low level, and the high-level signal may be sent to the 13th second GOA circuit 57. When G_CLK2 is at a low level, an output end of the 13th second GOA circuit 57 outputs a high-level pulse signal. Similarly, an output end of a previous second GOA circuit 57 provides high-level signals for input ends of a 14th second GOA circuit 57 to a 16th second GOA circuit 57 in the same partition, and may also output a high-level pulse signal.

Therefore, when the 1st second GOA circuit 57 in the second GOA circuit combination outputs a valid pulse signal, VFE4 is set to a low level, and VFE3 and VFE7 are set to a high level. When a last second GOA circuit 57 in a previous second GOA circuit combination outputs a valid low-level pulse, the second GOA circuit 57 in this combination does not output a valid low-level pulse signal, that is, VFE3 is set to a low level, and VFE4 and VFE7 are set to a high level. When a last second GOA circuit 57 in a previous second GOA circuit combination does not output a valid low-level pulse, the second GOA circuit 57 in this combination outputs a valid low-level pulse signal, that is, VFE4 is set to a low level, and VFE3 and VFE7 are set to a high level. At other time, VFE7 is set to a low level, and VFE3 and VFE4 are set to a high level for cascaded transmission. Therefore, even if there are a large quantity of partition units, if output pulse signals of most partition units do not change abruptly, low levels of VFE3 and VFE4 can always be kept unchanged, thereby further reducing power consumption.

It may be understood that, if the second GOA circuit 57 outputs a valid high-level pulse signal, only the drain of the first thin film transistor 561 needs to be coupled to a node having a high-level pulse signal with a row-by-row shift, and the drain of the second thin film transistor 562 needs to be coupled to a power output end having a low level.

Optionally, each first GOA circuit combination includes m first GOA circuits, m is an integer greater than or equal to 1, and p first GOA circuit combinations in each circuit group are respectively coupled to the p first partition control signal lines.

For example, all the first GOA circuit combinations may have a same quantity of circuits. In this case, the drive circuit 50 may include n*m first GOA circuits 51.

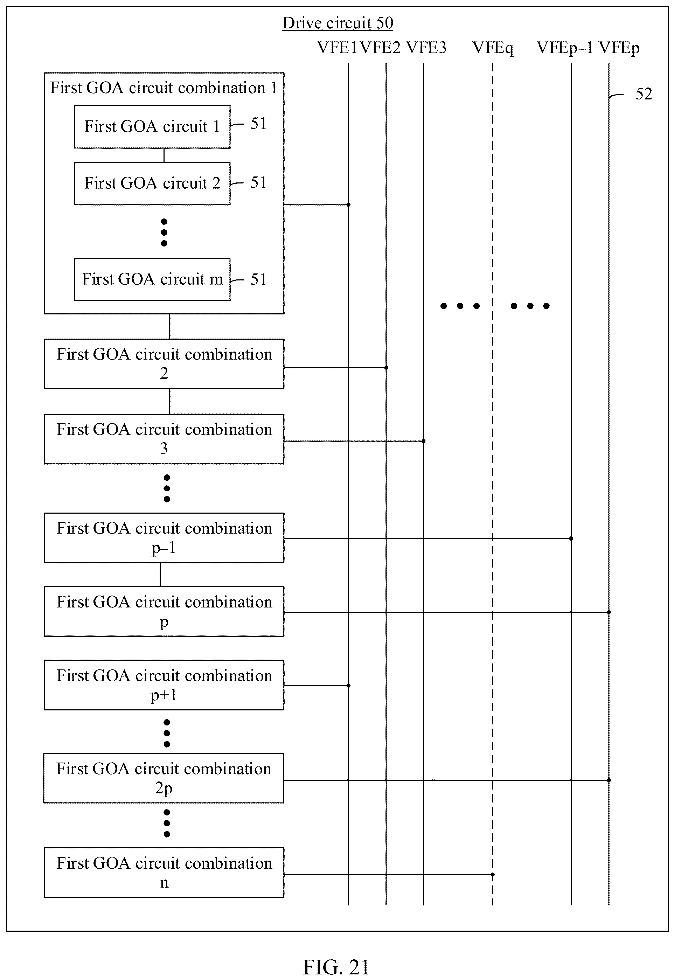

In a possible example, it is assumed that a remainder of n/p is q. If q is greater than or equal to 1 and less than p, that is, n is not an integer multiple of p, an $n^{th}$ first GOA circuit combination is coupled to a $q^{th}$ first control signal line. It may be understood that, if q=0, that is, n is an integer multiple of p, the $n^{th}$ first GOA circuit combination is coupled to a $p^{th}$ first partition control signal line. FIG. 21 is a circuit diagram of still another drive circuit according to an embodiment of this application. A first GOA circuit combination 1 to a first GOA circuit combination p are respectively coupled to VFE1 to VFEp, a first GOA circuit combination p+1 to a first GOA circuit combination 2p are respectively coupled to VFE1 to VFEp, and a first GOA circuit n is coupled to VFEq.

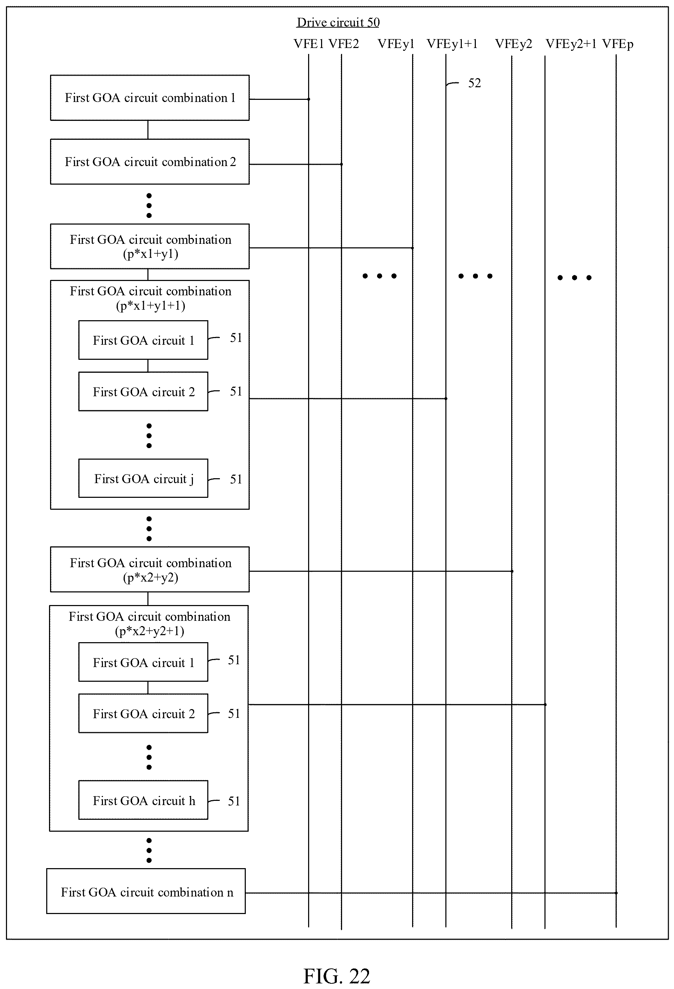

Optionally, each first GOA circuit combination in a $1^{st}$ first GOA circuit combination in the n first GOA circuit combinations to a $(p*x1+y1)^{th}$ first GOA circuit combination includes m first GOA circuits, m is an integer greater than or equal to 1, each first GOA circuit combination in a $(p*x1+y1+1)^{th}$ first GOA circuit combination to a $(p*x2+y2)^{th}$ first GOA circuit combination includes j first GOA circuits, and each first GOA circuit combination in a $(p*x2+y2+1)^{th}$ first GOA circuit combination to an $n^{th}$ first GOA circuit combination includes h first GOA circuits, where x1 is an integer greater than or equal to 0 and less than or equal to (n-y)/p, x2 is an integer greater than or equal to x1 and less than or equal to (n-y)/p, y1 is an integer greater than or equal to 1 and less than or equal to p, y2 is an integer greater than or equal to 1 and less than or equal to p, j is an integer greater than or equal to 1 and less than or equal to m, and h is an integer greater than or equal to 1 and less than m. For example, the n first GOA circuit combinations may have a plurality of first GOA circuits 51 of different quantities. FIG. 22 is a circuit diagram of still another drive circuit according to an embodiment of this application. It may be understood that, when y1 is equal to p, y1+1 needs to be understood as 1. In this case, the first GOA circuit combination p*x1+y1+1 is coupled to VFE1. When y2 is equal to p, y2+1 needs to be understood as 1. In this case, the first GOA circuit combination p*x1+y2+1 is coupled to VFE1.

Optionally, the drive circuit 50 may further include a third GOA circuit combination and a fourth circuit combination. Each first partition control signal line 52 is coupled with g third GOA circuit combinations close to the first end, and each first partition control signal line 52 is coupled with k fourth GOA circuit combinations close to the second end, where g is an integer greater than or equal to 1, and k is an integer greater than or equal to 1; and output pulse signals of the third GOA circuit combination and the fourth GOA circuit combination are not transmitted to a pixel screen.

For example, the first end of the first partition control signal line 52 may be an end close to a signal source, and the second end of the first partition control signal line 52 may be an end far away from the signal source. At an end close to the signal source, that is, at a start position of the first partition control signal line 52, there is almost no resistance on the first partition control signal line 52, and a voltage on the first partition control signal line 52 is closest to a start signal voltage of the signal source. At an end far away from the signal source, that is, at an end position of the first partition control signal line 52, a voltage on the first partition control signal line 52 deviates most from a start signal voltage of the signal source after a very long line resistance.

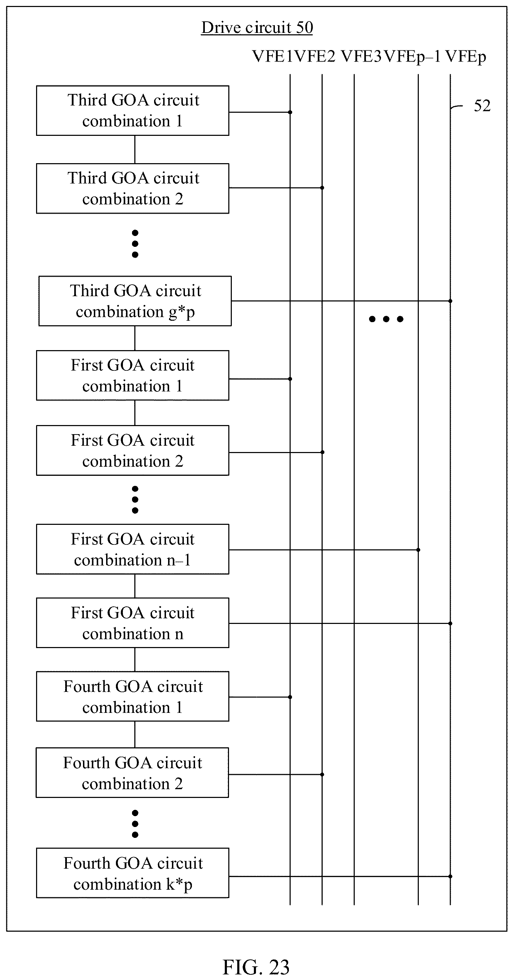

FIG. 23 is a circuit diagram of still another drive circuit according to an embodiment of this application. FIG. 23 shows g*p third GOA circuit combinations and k*p fourth GOA circuit combinations. A third GOA circuit combination 1 is coupled to VFE1, a third GOA circuit combination 2 is coupled to a $2^{nd}$ first partition control signal line (that is, VFE2), and a third GOA circuit combination g*p is coupled to VFEp. A fourth GOA circuit combination 1 is coupled to VFE1, a fourth GOA circuit combination 2 is coupled to VFE2, and a fourth GOA circuit combination k*p is coupled to VFEp. The third GOA circuit combinations and the fourth GOA circuit combinations are respectively coupled to the p first partition control signal lines alternately.

A quantity of third GOA circuits in each third GOA circuit combination and a quantity of fourth GOA circuits in each fourth GOA circuit combination may be flexibly set according to frame space of the pixel screen. In addition, the third GOA circuit may be the same as the first GOA circuit 51, or the third GOA circuit may be different from the first GOA circuit 51. The fourth GOA circuit may be the same as the first GOA circuit 51, or the fourth GOA circuit may be different from the first GOA circuit 51.

Output pulse signals of the third GOA circuit combination and the fourth GOA circuit combination are not transmitted to a valid pixel area of the pixel screen, that is, floating (floating) processing is performed on output ends of the third GOA circuit and the fourth GOA circuit. The output ends are in a high-resistance state, that is, a control signal of a 1st row of pixels in the pixel screen comes from a 1st first GOA circuit 51 of the first GOA circuit combination 1, and a control signal of a last row of pixels in the pixel screen comes from a last first GOA circuit 51 of the first GOA circuit combination n.

Therefore, a voltage difference between the control signal of the 1 st row of pixels in the pixel screen and the control signal of the last row of pixels in the pixel screen can be reduced, thereby improving a display effect.

Optionally, line lengths from start ends to end ends of the p first partition control signal lines are the same.

For example, refer to FIG. 5. m first GOA circuits 51 in the first GOA circuit combination 1 are coupled to closest VFE1, and m first GOA circuits 51 in the first GOA circuit combination 2 are coupled to second closest VFE2. By analogy, m first GOA circuits 51 in a first GOA circuit combination p are coupled to farthest VFEp. In this case, a signal on VFEp needs to be transmitted to the first GOA circuit combination p through a long horizontal connection line. Because lengths of horizontal transmission lines between the p first partition control signal lines 52 are different, the signal lines are different in impedance and parasitic capacitance load, and consequently output pulse signals of the first GOA circuits 51 are different, affecting a display effect. Therefore, when the p first partition control signal lines are disposed, the line lengths from the starts end to the end ends of the p first partition control signal lines need to be the same, to reduce differences in the signal lines and parasitic capacitance load.

In an example, a formula for an impedance R of the first partition control signal line 52 is $R = \rho * \frac{L}{S}$, , where $\rho$ is a resistivity, S is a cross-sectional area of the first partition control signal line 52, and L is a line length of the first partition control signal line 52. The resistivity is related to a material of the first partition control signal line 52. Therefore, the p first partition control signal lines 52 have a same resistivity. In a same drive circuit 50, cross-sectional areas of the p first partition control signal lines 52 may be the same. That is, if the line lengths of the p first partition control signal lines 52 are the same, the p first partition control signal lines 52 have a same impedance, which can eliminate a difference between output pulse signals of the first GOA circuits 51.

Optionally, the p first partition control signal lines are coupled to the plurality of first GOA circuits 51 through a first conductive layer and a second conductive layer of a substrate of the drive circuit 50, the start ends of the p first partition control signal lines are located at the first conductive layer, the second conductive layer and the first conductive layer are disposed opposite to each other, and the first conductive layer is connected to the second conductive layer through a connection hole; and a plurality of overlapping capacitors further exist on the p first partition control signal lines, the plurality of overlapping capacitors are formed by overlapping the first conductive layer and the second conductive layer, and a same quantity of overlapping capacitors exist between any adjacent connection holes on the p first partition control signal lines.

For example, the p first partition control signal lines 52 may have a plurality of segments, two adjacent segments are distributed at different conductive layers of the substrate of the drive circuit 50, and p-1 overlapping capacitors may exist between any adjacent connection holes on the p first partition control signal lines.

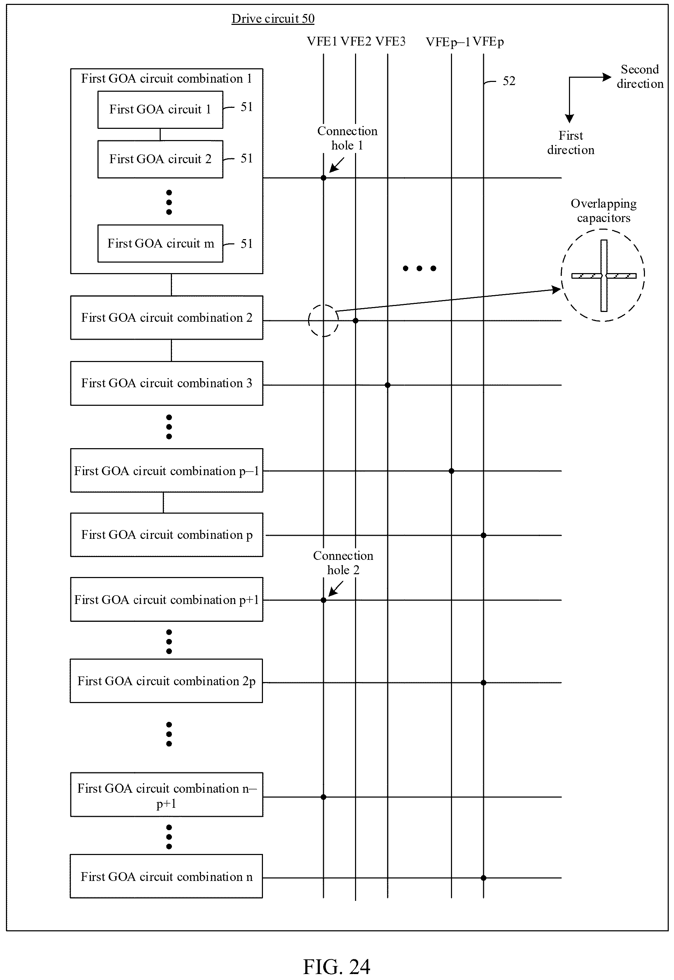

In a possible example, FIG. 24 is a diagram of a distribution of p first partition control signal lines according to an embodiment of this application. The p first partition control signal lines 52 may be distributed at the first conductive layer along a first direction, and horizontal connection lines between the p first partition control signal lines 52 and the plurality of first GOA circuits 51 may be distributed at the second conductive layer along a second direction. Using the first GOA circuit combination 1 and the first GOA circuit combination p+1 an example, a horizontal connection line of the first GOA circuit combination 1 is coupled to VFE1 through a connection hole 1, a horizontal connection line of the first GOA circuit combination p+1 is coupled to VFE1 through a connection hole 2, and the two horizontal connection lines further extend to VFEp. A horizontal connection line of each first GOA circuit 51 and an extension line of the horizontal connection line have a same bus length. It may be understood that there is no electrical connection between the extension line of the horizontal connection line and the first partition control signal line 52. In addition, the horizontal connection line may further extend beyond VFEp. A line length by which the horizontal connection line extends beyond VFEp is not limited in embodiments of this application. There may be p-1 overlapping capacitors between the connection hole 1 and the connection hole 2. In addition, there are also p-1 overlapping capacitors between the extension line of the horizontal connection line and each of the p first partition control signal lines. By analogy, there may be p-1 overlapping capacitors between any adjacent connection holes on the p first partition control signal lines 52. In this case, the p first partition control signal lines 52 have a same impedance, which can eliminate a difference between output pulse signals of the first GOA circuits 51.

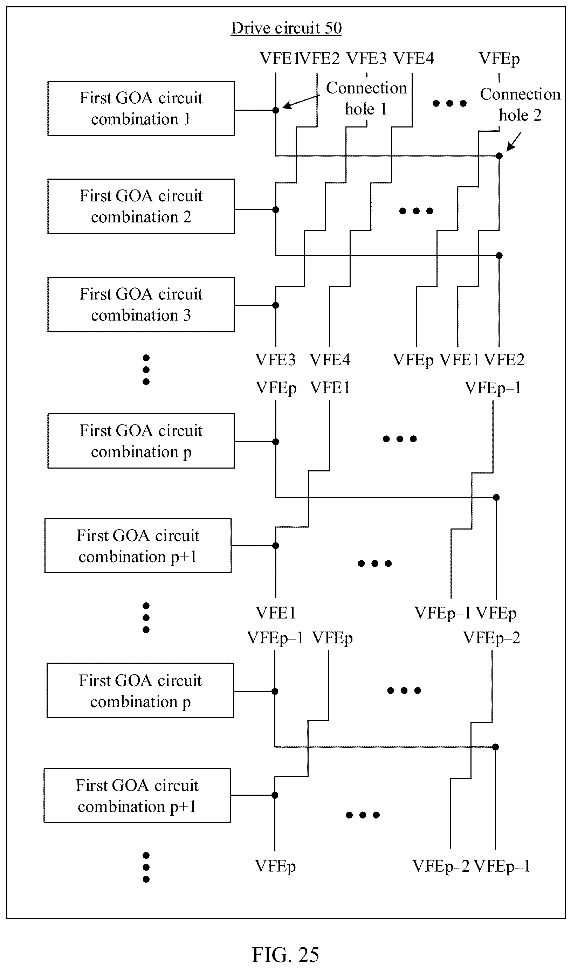

In another possible example, FIG. 25 is a diagram of another distribution of p first partition control signal lines according to an embodiment of this application. Line lengths of horizontal connection lines between each first GOA circuit 51 and the first partition control signal lines 52 are the same, and the horizontal connection line is coupled to the first partition control signal line 52 through a connection hole. In addition, each first partition control signal line 52 is distributed in a non-linear manner, which can meet a requirement that the first partition control signal line 52 is distributed closest to the corresponding first GOA circuit 51. Specifically, a $y^{th}$ first partition control signal line is transposed to a position of a $(y-1)^{th}$ first partition control signal line for every first GOA circuit combination, until the $y^{th}$ first partition control signal line is transposed to a position of original VFE1, and is coupled to each first GOA circuit 51 of a $(px+y)^{th}$ first partition control signal line combination in the n first GOA circuit combinations. After the current coupling is completed, the $y^{th}$ first partition control signal line is horizontally transposed at a next first GOA circuit combination to a farthest position, that is, the position of original VFEp.

Using VFE1 as an example, a signal line between a start end of VFE1 and the connection hole 1 may be distributed at the first conductive layer, a signal line between the connection hole 1 and the connection hole 2 may be distributed at the second conductive layer, and a signal line between the connection hole 2 and a next connection hole may be distributed at the first conductive layer. There are p-1 first partition control signal lines 52 between the connection hole 1 and the connection hole 2, that is, there may be p-1 overlapping capacitors between the connection hole 1 and the connection hole 2. By analogy, there may be p-1 overlapping capacitors between any adjacent connection holes on the p first partition control signal lines 52. In this case, the p first partition control signal lines 52 have a same impedance, which can eliminate a difference between output pulse signals of the first GOA circuits 51.

The following describes a driving method provided in embodiments of this application when the driving method is applied to the foregoing drive circuit.

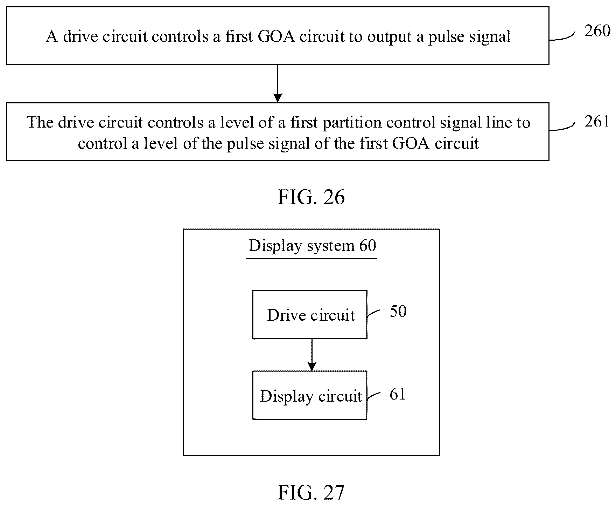

FIG. 26 is a flowchart of a driving method according to an embodiment of this application. The driving method includes the following procedure.

Step 260: The drive circuit controls a first GOA circuit to output a pulse signal.

Step 261: The drive circuit controls a level of a first partition control signal line to control a level of the pulse signal of the first GOA circuit.

For example, one first GOA circuit combination may be understood as one partition, and first GOA circuit combinations of different partitions may be controlled by different first partition control signal lines. During partition refresh, for overlapping pulse signals, it can be ensured that a pulse signal of a first GOA circuit coupled to a current first partition control signal line is not affected by level switching of another first partition control signal line, and it is ensured that a width of the pulse signal is the same as an actual required width, thereby implementing a partitioning function. For specific implementations of step 210 and step 211, refer to the foregoing description of the drive circuit.

FIG. 27 is a diagram of a structure of a display system according to an embodiment of this application. An embodiment of this application further provides a display system 60. The display system 60 includes the drive circuit 50 and a display circuit 61. The drive circuit 50 is configured to transmit a pulse signal to the display circuit 61, and the display circuit 61 is configured to display an image based on the pulse signal.

An embodiment of this application further provides an electronic device. The electronic device includes a printed circuit board and the drive circuit. The drive circuit is electrically connected to the printed circuit board.

It may be understood that, to implement the foregoing functions, the electronic device includes a corresponding hardware and/or software module for performing each function. With reference to algorithm steps of examples described in embodiments disclosed in this specification, this application can be implemented in a form of hardware or a combination of hardware and computer software. Whether a function is performed by hardware or hardware driven by computer software depends on particular applications and design constraints of the technical solutions. A person skilled in the art may use different methods to implement the described functions with reference to embodiments for each particular application, but it should not be considered that the implementation goes beyond the scope of this application.

An embodiment of this application further provides a computer storage medium. The computer storage medium stores computer instructions. When the computer instructions are run on an electronic device, the electronic device is enabled to perform the foregoing related method steps, to implement the driving method in the foregoing embodiments.

An embodiment of this application further provides a computer program product. When the computer program product runs on a computer, the computer is enabled to perform the foregoing related steps, to implement the driving method performed by the electronic device in the foregoing embodiments.

In addition, an embodiment of this application further provides an apparatus. The apparatus may be specifically a chip, a component, or a module. The apparatus may include a processor and a memory that are connected. The memory is configured to store computer-executable instructions. When the apparatus runs, the processor may execute the computer-executable instructions stored in the memory, so that the chip performs the driving method performed by the electronic device in the foregoing method embodiments.

The electronic device, the computer storage medium, the computer program product, or the chip provided in embodiments is configured to perform the corresponding method provided above. Therefore, for beneficial effect that can be achieved, refer to beneficial effect of the corresponding method provided above. Details are not described herein again.

Based on the descriptions about the foregoing implementations, a person skilled in the art may understand that, for a purpose of convenient and brief description, division into the foregoing functional modules is used as an example for illustration. In actual application, the foregoing functions may be allocated to different functional modules and implemented based on requirements. In other words, an inner structure of an apparatus is divided into different functional modules to implement all or some of the functions described above.

In the several embodiments provided in this application, it should be understood that the disclosed apparatus and method may be implemented in other manners. For example, the described apparatus embodiment is merely an example. For example, the module or division into the units is merely logical function division and may be other division in actual implementation. For example, a plurality of units or components may be combined or integrated into another apparatus, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may be one or more physical units, may be located in one place, or may be distributed on different places. Some or all of the units may be selected based on actual requirements to achieve the objectives of the solutions of embodiments.

In addition, functional units in embodiments of this application may be integrated into one processing unit, each of the units may exist alone physically, or two or more units may be integrated into one unit. The integrated unit may be implemented in a form of hardware, or may be implemented in a form of a software functional unit.

When the integrated unit is implemented in the form of a software functional unit and sold or used as an independent product, the integrated unit may be stored in a readable storage medium. Based on such an understanding, the technical solutions of embodiments of this application essentially, or the part contributing to the conventional technology, or all or some of the technical solutions may be implemented in the form of a software product. The software product is stored in a storage medium and includes several instructions for instructing a device (which may be a single-chip microcomputer, a chip or the like) or a processor (processor) to perform all or some of the steps of the methods described in embodiments of this application. The storage medium includes various media that can store program code, such as a USB flash drive, a removable hard disk, a read-only memory (read-only memory, ROM), a random access memory (random access memory, RAM), a magnetic disk, or an optical disc.

The foregoing descriptions are merely specific implementations of this application, but are not intended to limit the protection scope of this application. Any variation or replacement readily figured out by a person skilled in the art in the technical scope disclosed in this application shall fall within the protection scope of this application. Therefore, the protection scope of this application shall be subject to the protection scope of the claims.

## Claims

1. A drive circuit, comprising a plurality of first gate driver on array GOA circuits and p first partition control signal lines, p is an integer greater than or equal to 2, the plurality of first GOA circuits are sequentially cascaded, the plurality of first GOA circuits comprise n first GOA circuit combinations, n is an integer greater than or equal to p, and first GOA circuits in each first GOA circuit combination are sequentially cascaded; and a partition control end of each first GOA circuit in a $(px+y)^{th}$ first GOA circuit combination in the n first GOA circuit combinations is coupled to a $y^{th}$ first partition control signal line in the p first partition control signal lines, x is an integer greater than or equal to 0 and less than or equal to (n-y)/p, and y is an integer greater than or equal to 1 and less than or equal to p.

2. The circuit according to claim 1, wherein the drive circuit further comprises a second partition control signal line, a third partition control signal line, a plurality of control circuits, and a plurality of second GOA circuits; and the plurality of second GOA circuits are sequentially cascaded, the plurality of second GOA circuits comprise a plurality of second GOA circuit combinations, second GOA circuits in each second GOA circuit combination are sequentially cascaded, a quantity of second GOA circuit combinations is the same as a quantity of control circuits, control ends of the plurality of control circuits are coupled to the second partition control signal line and the third partition control signal line, a first end of each control circuit in the plurality of control circuits is coupled to the first GOA circuit combination, and a second end of each control circuit in the plurality of control circuits is coupled to a corresponding second GOA circuit combination.

3. The circuit according to claim 2, wherein the control circuit comprises a first thin film transistor and a second thin film transistor; a drain of the first thin film transistor is coupled to the first end of the control circuit, a gate of the first thin film transistor is coupled to the second partition control signal line, and a source of the first thin film transistor is coupled to the second end of the control circuit; and a drain of the second thin film transistor is coupled to a power output end, a gate of the second thin film transistor is coupled to the third partition control signal line, and a source of the second thin film transistor is coupled to the second end of the control circuit.

4. The circuit according to claim 3, wherein the drive circuit further comprises a fourth partition control signal line, a gate of the first thin film transistor of a $(2i-1)^{th}$ control circuit in the plurality of control circuits is coupled to the second partition control signal line, i is a positive integer, and a gate of the first thin film transistor of a $(2i)^{th}$ control circuit in the plurality of control circuits is coupled to the fourth partition control signal line.

5. The circuit according to claim 2, wherein the control circuit comprises a third thin film transistor and a fourth thin film transistor; a drain of the third thin film transistor is coupled to the second partition control signal line, a gate of the third thin film transistor is coupled to the first end of the control circuit, and a source of the third thin film transistor is coupled to the second end of the control circuit; and a drain of the fourth thin film transistor is coupled to a power output end, a gate of the fourth thin film transistor is coupled to the third partition control signal line, and a source of the fourth thin film transistor is coupled to the second end of the control circuit.

6. The circuit according to claim 5, wherein the drive circuit further comprises a fifth partition control signal line, a drain of the third thin film transistor of a $(2j-1)^{th}$ control circuit in the plurality of control circuits is coupled to the second partition control signal line, j is a positive integer, and a drain of the third thin film transistor of a $(2j)^{th}$ control circuit in the plurality of control circuits is coupled to the fifth partition control signal line.

7. The circuit according to claim 3, wherein the drive circuit further comprises a plurality of fifth thin film transistors and a sixth partition control signal line, a drain of the fifth thin film transistor is coupled to an output end of a last second GOA circuit in the second GOA circuit combination, a source of the fifth thin film transistor is coupled to an input end of a $1^{st}$ second GOA circuit in a next second GOA circuit combination, and a gate of the fifth thin film transistor is coupled to the sixth partition control signal line.

8. The circuit according to any one of claims 1 to 7, wherein the drive circuit further comprises a start-of-frame signal line, and a width of a pulse signal of the first GOA circuit is determined by a width of a pulse signal of the start-of-frame signal line.

9. The circuit according to claim 8, wherein a quantity of first GOA circuits in the first GOA circuit combination is related to a quantity of first partition control signal lines and the width of the pulse signal of the first GOA circuit.

10. The circuit according to claim 9, wherein when the first partition control signal line outputs a high level, the pulse signal of the first GOA circuit is at a high level, or when the first partition control signal line outputs a low level, the pulse signal of the first GOA circuit is at a low level.

11. The circuit according to claim 1, wherein each first GOA circuit combination comprises m first GOA circuits, m is an integer greater than or equal to 1, and every p first GOA circuit combinations are respectively coupled to the p first partition control signal lines.

12. The circuit according to claim 1, wherein each first GOA circuit combination in a $1^{st}$ first GOA circuit combination in the n first GOA circuit combinations to a $(p*x1+y1)^{th}$ first GOA circuit combination comprises m first GOA circuits, m is an integer greater than or equal to 1, each first GOA circuit combination in a $(p*x1+y1+1)^{th}$ first GOA circuit combination to a $(p*x2+y2)^{th}$ first GOA circuit combination comprises j first GOA circuits, and each first GOA circuit combination in a $(p*x2+y2+1)^{th}$ first GOA circuit combination to an $n^{th}$ first GOA circuit combination comprises h first GOA circuits, wherein x1 is an integer greater than or equal to 0 and less than or equal to $(n-y)/p$, x2 is an integer greater than or equal to x1 and less than or equal to $(n-y)/p$, y1 is an integer greater than or equal to 1 and less than or equal to p, y2 is an integer greater than or equal to 1 and less than or equal to p, j is an integer greater than or equal to 1 and less than or equal to m, and h is an integer greater than or equal to 1 and less than m.

13. The circuit according to any one of claims 1 to 12, wherein the drive circuit further comprises a third GOA circuit combination and a fourth GOA circuit combination;

    each first partition control signal line is coupled with g third GOA circuit combinations close to the first end, and each first partition control signal line is coupled with k fourth GOA circuit combinations close to the second end, wherein g is an integer greater than or equal to 1, and k is an integer greater than or equal to 1; and output pulse signals of the third GOA circuit combination and the fourth GOA circuit combination are not transmitted to a pixel screen.

14. The circuit according to any one of claims 1 to 13, wherein line lengths from start ends to end ends of the p first partition control signal lines are the same.

15. The circuit according to claim 14, wherein the p first partition control signal lines are coupled to the plurality of first GOA circuits through a first conductive layer and a second conductive layer of a substrate of the drive circuit, the start ends of the p first partition control signal lines are located at the first conductive layer, the second conductive layer and the first conductive layer are disposed opposite to each other, and the first conductive layer is connected to the second conductive layer through a connection hole; and a plurality of overlapping capacitors further exist on the p first partition control signal lines, the plurality of overlapping capacitors are formed by overlapping the first conductive layer and the second conductive layer, and a same quantity of overlapping capacitors exist between any adjacent connection holes on the p first partition control signal lines.

16. A driving method, wherein the method is applied to a drive circuit; the drive circuit comprises a plurality of first gate driver on array GOA circuits and p first partition control signal lines, p is an integer greater than or equal to 2, the plurality of first GOA circuits are sequentially cascaded, the plurality of first GOA circuits comprise n first GOA circuit combinations, n is an integer greater than or equal to p, and first GOA circuits in each first GOA circuit combination are sequentially cascaded; a partition control end of each first GOA circuit in a $(px+y)^{th}$ first GOA circuit combination in the n first GOA circuit combinations is coupled to a $y^{th}$ first partition control signal line in the p first partition control signal lines, x is an integer greater than or equal to 0 and less than or equal to (n-y)/p, and y is an integer greater than or equal to 1 and less than or equal to p; and the method comprises:

controlling the first GOA circuit to output a pulse signal; and
controlling a level of the first partition control signal line to control a level of the pulse signal of the first GOA circuit.

17. The method according to claim 16, wherein when the first partition control signal line outputs a high level, the pulse signal of the first GOA circuit is at a high level, or when the first partition control signal line outputs a low level, the pulse signal of the first GOA circuit is at a low level.

18. A display system, comprising the drive circuit according to any one of claims 1 to 15 and a display circuit, wherein the drive circuit is configured to transmit a pulse signal to the display circuit, and the display circuit is configured to display an image based on the pulse signal.

19. An electronic device, wherein the electronic device comprises a printed circuit board and the drive circuit according to any one of claims 1 to 15, and the drive circuit is electrically connected to the printed circuit board.

20. A computer-readable storage medium, comprising computer instructions, wherein when the computer instructions are run on an electronic device, the electronic device is enabled to perform the method according to claim 16 or 17.

(a)

(b)

FIG. 1

FIG. 2

Pulse signals of a GOA circuit do not overlap

Pulse signals of a GOA circuit overlap

Disable a partitioning function

OUT1
OUT2
OUT3
OUT4

Output a pulse signal

Enable a partitioning function

OUT1
OUT2

Output a pulse signal

OUT3
OUT4

Output no pulse signal

STV
CLK1
CLK2
VFE
PU1
PU2
PU3
PU4
PD1
PD2
PD3
PD4
OUT1
OUT2
OUT3
OUT4

(a)

(b)

(c)

(d)

FIG. 3

Display 40

42    41    42

Drive circuit

Pixel screen

Drive circuit

DDIC    43

44

FPC

FIG. 4

Drive circuit 50

VFE1 VFE2 VFE3    VFEp–1 VFEp

First GOA circuit combination 1

First GOA circuit 1 — 51

First GOA circuit 2 — 51

First GOA circuit m — 51

— 52

First GOA circuit combination 2

First GOA circuit combination 3

First GOA circuit combination n–1

First GOA circuit combination n

FIG. 5

FIG. 6

FIG. 7

FIG. 8

FIG. 9

EP 4 693 267 A1

FIG. 10

FIG. 11

FIG. 12

FIG. 13

FIG. 14

FIG. 15

FIG. 16

FIG. 17

FIG. 18

FIG. 19

FIG. 20

FIG. 21

Drive circuit 50

VFE1 VFE2    VFEy1   VFEy1+1    VFEy2   VFEy2+1 VFEp

First GOA circuit combination 1

52

First GOA circuit combination 2

First GOA circuit combination
(p*x1+y1)

First GOA circuit combination
(p*x1+y1+1)

First GOA circuit 1    51

First GOA circuit 2    51

First GOA circuit j    51

First GOA circuit combination
(p*x2+y2)

First GOA circuit combination
(p*x2+y2+1)

First GOA circuit 1    51

First GOA circuit 2    51

First GOA circuit h    51

First GOA circuit combination n

FIG. 22

Drive circuit 50

VFE1 VFE2 VFE3 VFEp–1 VFEp

Third GOA circuit
combination 1

52

Third GOA circuit
combination 2

Third GOA circuit
combination g*p

First GOA circuit
combination 1

First GOA circuit
combination 2

First GOA circuit
combination n–1

First GOA circuit
combination n

Fourth GOA circuit
combination 1

Fourth GOA circuit
combination 2

Fourth GOA circuit
combination k*p

FIG. 23

Drive circuit 50

VFE1 VFE2 VFE3    VFEp−1 VFEp

Second direction

First GOA circuit combination 1

First GOA circuit 1 — 51

First GOA circuit 2 — 51

First GOA circuit m — 51

52

First direction

Connection hole 1

Overlapping capacitors

First GOA circuit combination 2

· · ·

First GOA circuit combination 3

First GOA circuit combination p−1

First GOA circuit combination p

Connection hole 2

First GOA circuit combination p+1

First GOA circuit combination 2p

First GOA circuit combination n−p+1

First GOA circuit combination n

FIG. 24

FIG. 25

A drive circuit controls a first GOA circuit to output a pulse signal  —  260

The drive circuit controls a level of a first partition control signal line to control a level of the pulse signal of the first GOA circuit  —  261

FIG. 26

Display system 60

Drive circuit  — 50

Display circuit  — 61

FIG. 27

## INTERNATIONAL SEARCH REPORT

| International application No. |
| --- |
| **PCT/CN2024/077960** |

**A.   CLASSIFICATION OF SUBJECT MATTER**

G09G3/3208(2016.01)i;  G11C19/28(2006.01)i;  G02F1/13(2006.01)i

According to International Patent Classification (IPC) or to both national classification and IPC

**B.   FIELDS SEARCHED**

Minimum documentation searched (classification system followed by classification symbols)

IPC:G09G G11C G02F

Documentation searched other than minimum documentation to the extent that such documents are included in the fields searched

Electronic data base consulted during the international search (name of data base and, where practicable, search terms used)

CNTXT, ENTXT, ENTXTC, VEN, CNKI, CJFD: 移位缓存, 移位寄存, 移位暂存, 闸级驱动, 栅极驱动, 扫描驱动, 行驱动, 行扫描, 选通驱动, 门级驱动, 分区, 分组, 局部, 功耗, 功率消耗, 能耗, 节能, 省电, 电力消耗, 脉冲, 扫描信号, 交叉, 交错, 交叠, 偶数, 奇数, 控制线, GIA, GIP, GOA, shift register, scan+ driv+, gate driv+, power, electric+, energy, consumpt+, sav +, dissipat+, part+, area?, local+, region+, group+, zone+, display+, pulse, output+, across+, interleav+, overlap+, intersect+, intercross+, odd, even

**C.   DOCUMENTS CONSIDERED TO BE RELEVANT**

| Category* | Citation of document, with indication, where appropriate, of the relevant passages | Relevant to claim No. |
| --- | --- | --- |
| A | CN 115798414 A (BOE TECHNOLOGY GROUP CO., LTD. et al.) 14 March 2023 (2023-03-14)<br>    description, paragraphs 65-70 and 87-103, and figures 6 and 10 | 1-20 |
| A | CN 101268503 A (KONINKL PHILIPS ELECTRONICS N.V.) 17 September 2008 (2008-09-17)<br>    entire document | 1-20 |
| A | CN 104700765 A (LG DISPLAY CO., LTD.) 10 June 2015 (2015-06-10)<br>    entire document | 1-20 |
| A | CN 111798806 A (SHANGHAI AVIC OPTOELECTRONICS CO., LTD.) 20 October 2020 (2020-10-20)<br>    entire document | 1-20 |

☑ Further documents are listed in the continuation of Box C.          ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **23 April 2024** | **14 May 2024** |

| Name and mailing address of the ISA/CN | Authorized officer |
| --- | --- |
| **China National Intellectual Property Administration (ISA/ CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
| --- |
| **PCT/CN2024/077960** |

**C.      DOCUMENTS CONSIDERED TO BE RELEVANT**

| Category* | Citation of document, with indication, where appropriate, of the relevant passages | Relevant to claim No. |
| --- | --- | --- |
| A | CN 115775547 A (BOE TECHNOLOGY GROUP CO., LTD. et al.) 10 March 2023 (2023-03-10)<br>    entire document | 1-20 |
| A | CN 113129823 A (LG DISPLAY CO., LTD.) 16 July 2021 (2021-07-16)<br>    entire document | 1-20 |
| A | CN 115831205 A (BEIJING BOE TECHNOLOGY DEVELOPMENT CO., LTD. et al.) 21 March 2023 (2023-03-21)<br>    entire document | 1-20 |
| A | CN 109389934 A (XIAMEN TIANMA MICRO-ELECTRONICS CO., LTD.) 26 February 2019 (2019-02-26)<br>    entire document | 1-20 |
| A | US 2021201816 A1 (LG DISPLAY CO., LTD.) 01 July 2021 (2021-07-01)<br>    entire document | 1-20 |
| A | WO 2022261933 A1 (BOE TECHNOLOGY GROUP CO., LTD.) 22 December 2022 (2022-12-22)<br>    entire document | 1-20 |

Form PCT/ISA/210 (second sheet) (July 2022)

## INTERNATIONAL SEARCH REPORT
### Information on patent family members

International application No.

**PCT/CN2024/077960**

| Patent document cited in search report | | | Publication date (day/month/year) | Patent family member(s) | | | Publication date (day/month/year) |
|---|---|---|---|---|---|---|---|
| CN | 115798414 | A | 14 March 2023 | None | | | |
| CN | 101268503 | A | 17 September 2008 | JP | 2009509190 | A | 05 March 2009 |
| | | | | JP | 5058168 | B2 | 24 October 2012 |
| | | | | EP | 1929464 | A1 | 11 June 2008 |
| | | | | EP | 1929464 | B1 | 27 March 2013 |
| | | | | TW | 200717388 | A | 01 May 2007 |
| | | | | US | 2008225033 | A1 | 18 September 2008 |
| | | | | WO | 2007034364 | A1 | 29 March 2007 |
| | | | | CN | 101268503 | B | 10 November 2010 |
| CN | 104700765 | A | 10 June 2015 | US | 2015154902 | A1 | 04 June 2015 |
| | | | | US | 9824614 | B2 | 21 November 2017 |
| | | | | KR | 20150065572 | A | 15 June 2015 |
| | | | | KR | 102224890 | B1 | 10 March 2021 |
| | | | | CN | 104700765 | B | 27 June 2017 |
| CN | 111798806 | A | 20 October 2020 | CN | 111798806 | B | 29 March 2022 |
| CN | 115775547 | A | 10 March 2023 | None | | | |
| CN | 113129823 | A | 16 July 2021 | JP | 2021110942 | A | 02 August 2021 |
| | | | | JP | 7034245 | B2 | 11 March 2022 |
| | | | | GB | 202020466 | D0 | 03 February 2021 |
| | | | | GB | 2592299 | A | 25 August 2021 |
| | | | | GB | 2592299 | B | 23 March 2022 |
| | | | | KR | 20210085919 | A | 08 July 2021 |
| | | | | US | 2021201813 | A1 | 01 July 2021 |
| | | | | US | 11462171 | B2 | 04 October 2022 |
| | | | | CN | 113129823 | B | 08 March 2024 |
| CN | 115831205 | A | 21 March 2023 | None | | | |
| CN | 109389934 | A | 26 February 2019 | None | | | |
| US | 2021201816 | A1 | 01 July 2021 | US | 11211013 | B2 | 28 December 2021 |
| | | | | KR | 20210086295 | A | 08 July 2021 |
| WO | 2022261933 | A1 | 22 December 2022 | CN | 115836392 | A | 21 March 2023 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310541140
- CN 202311790984